# EUROPEAN PATENT APPLICATION

(11) **EP 4 734 114 A1**
(43) Date of publication of application: **29.04.2026**
(21) Application number: 25204888.9
(22) Date of filing: 26.09.2025
(51) Int. Cl.: G11C 11/406

(54) **MEMORY MODULE AND MEMORY SYSTEM INCLUDING THE MEMORY MODULE**

(30) Priority: 24.10.2024 KR 20240147064; 20.03.2025 KR 20250036138
(71) Applicant: Samsung Electronics Co., Ltd., Suwon-si, Gyeonggi-do 16677 (KR)
(72) Inventor: KIM, Chinam, 16677 Suwon-si, Gyeonggi-do (KR); KIM, Kwangsu, 16677 Suwon-si, Gyeonggi-do (KR); KIM, Do-Han, 16677 Suwon-si, Gyeonggi-do (KR); KIM, SuJin, 16677 Suwon-si, Gyeonggi-do (KR); LEE, Changmin, 16677 Suwon-si, Gyeonggi-do (KR)
(74) Representative: Kuhnen & Wacker Patent- und Rechtsanwaltsbüro PartG mbB

(57) **Abstract**

A memory module (1000) according to an embodiment of present disclosure may comprise: a first memory device (1100) including a first plurality of memory banks (BNK1_D1), a second plurality of memory banks (BNK2_D1), and a first refresh management circuit; and a second memory device (1200) including a third plurality of memory banks (BNK1_D2), a fourth plurality of memory banks (BNK2_D2), and a second refresh management circuit, wherein the first refresh management circuit is configured to manage a number of times refresh is performed for the first and third plurality of memory banks (BNK1_D1, BNK1_D2), and the second refresh management circuit is configured to manage a number of times refresh is performed for the second and fourth plurality of memory banks (BNK2_D1, BNK2_D2).

## Description

### BACKGROUND

### (a) Field

The present disclosure relates to a semiconductor memory device. More specifically, the present disclosure relates to a memory module including a plurality of memory devices, and a memory system including the same.

### (b) Description of the Related Art

A volatile memory device such as dynamic random access memory (DRAM) device may store data in a form of electrical charge stored in memory cells. The charge stored in the memory cells of the volatile memory device may gradually leak based on various factors. To maintain data integrity, the volatile memory device may periodically perform refresh operations to restore the electrical charge of the memory cells.

Because modern volatile memory devices are evolving toward higher integration, higher capacity, and faster input/output operation, the time proportion occupied by refresh operations among the total operating time of the volatile memory device is gradually increasing. In some applications, the input/output performance of the volatile memory device may be limited due to the increased refresh operations.

### SUMMARY

The present disclosure includes examples that address the technical issues described above. More specifically, aspects of the present disclosure describe a memory module configured to manage a number of refresh operations performed for a plurality of memory banks, and a memory system thereof.

A memory module according to an embodiment of present disclosure may comprise a first memory device including a first plurality of memory banks, a second plurality of memory banks, and a first refresh management circuit, and a second memory device including a third plurality of memory banks, a fourth plurality of memory banks, and a second refresh management circuit, wherein the first refresh management circuit is configured to manage a number of times refresh is performed for the first and third plurality of memory banks, and the second refresh management circuit is configured to manage a number of times refresh is performed for the second and fourth plurality of memory banks.

A memory system according to an embodiment of present disclosure may comprise a first memory device including a first plurality of memory banks identified with a first plurality of bank indexes and a second plurality of memory banks identified with a second plurality of bank indexes, a second memory device including a third plurality of memory banks identified with the first plurality of bank indexes and a fourth plurality of memory banks identified with the second plurality of bank indexes, and a host device configured to: poll, from the first memory device, a first skip allowance information generated based on a number of times refresh is performed for the first plurality of bank indexes during a first refresh management period; and determine, based on the first skip allowance information, a number of times to issue a regular refresh command for the first and third plurality of memory banks in a second refresh management period after the first refresh management period.

A memory module communicating with a host device according to an embodiment of present disclosure may comprise a plurality of memory devices including a plurality of memory banks, and a register clock driver configured to receive a command/address signal from the host device and to broadcast the command/address signal to the plurality of memory devices, wherein the register clock driver includes a refresh management circuit configured to manage a number of times refresh operation is performed for the plurality of memory banks based on the command/address signals.

A memory module according to an embodiment of present disclosure may comprise a first memory device including a first plurality of memory banks, a second plurality of memory banks, and a first distributed management circuit, and a second memory device including a third plurality of memory banks, a fourth plurality of memory banks, and a second distributed management circuit, wherein the first memory device and the second memory device are configured to share a command/address signal, the first distributed management circuit is configured to manage a first status information for the first and third plurality of memory banks based on the command/address signal, and the second distributed management circuit is configured to manage a second status information for the second and fourth plurality of memory banks based on the command/address signal.

### BRIEF DESCRIPTION OF THE DRAWINGS

FIG. 1 is a block diagram showing a memory system according to an embodiment of the present disclosure.
FIG. 2 is a diagram showing how a regular refresh operation is performed for one memory bank.
FIG. 3 is a diagram showing the operation of the refresh scheduling circuit of FIG. 1.
FIG. 4 is a diagram showing the operation of the refresh scheduling circuit of FIG. 1.
FIG. 5 is a diagram showing the operation of a memory system according to the embodiments of FIGS. 3 and 4.
FIGS. 6 to 9 are drawings exemplarily showing how a memory module generates skip allowance information according to the embodiment of FIG. 5.
FIG. 10 is a block diagram showing how a memory module manages the plurality of refresh credit counts according to an embodiment of the present disclosure.
FIG. 11 is a block diagram showing in more detail the configuration of one memory device according to the embodiment of FIG. 10.
FIG. 12 is a drawing showing the operation of the first refresh management circuit of FIG. 11 in more detail.
FIG. 13 is a diagram showing how the memory banks to be managed by each memory device of FIG. 10 are determined.
FIG. 14 is a diagram showing how a host device reads skip allowance information from the memory devices of FIG. 10.
FIG. 15 is a flowchart showing how a host device controls the operation of a memory module according to an embodiment of the present disclosure.
FIG. 16 is a diagram showing how a host device reads a refresh credit count according to an embodiment.
FIG. 17 is a diagram showing how a host device accesses a refresh credit counter array included in each memory device according to an embodiment.
FIG. 18 is a block diagram showing how a register clock driver manages the plurality of refresh credit counts according to an embodiment of the present disclosure.
FIG. 19 is a drawing showing the configuration of the refresh management circuit of FIG. 18 in more detail.
FIG. 20 is a diagram showing the configuration of a memory module according to an embodiment.
FIG. 21 is a block diagram showing the configuration of a memory module according to an embodiment.
FIG. 22 is a block diagram showing the configuration of a memory module according to an embodiment.

### DETAILED DESCRIPTION OF THE EMBODIMENTS

Hereinafter, various embodiments will be described in detail and clearly to such an extent that an ordinary one in the art easily implements the present disclosure. Specific details such as detailed components and structures are merely provided to assist the overall understanding of the various embodiments. Moreover, descriptions of well-known functions and structures are omitted for clarity and brevity. In the following drawings or in the detailed description, configurations may be connected to components other than components explicitly illustrated in the drawings or described in the detailed description. The terms described below are terms defined based on the functions of the present disclosure and are not limited to any particular function. The definitions of the terms should be interpreted in light of the entire specification.

Components that are described in the detailed description with reference to various terms will be implemented with software, hardware, or a combination thereof. For example, the software may be a machine code, firmware, an embedded code, and application software. For example, the hardware may include an electrical circuit, an electronic circuit, a processor, a computer, integrated circuit cores, a pressure sensor, a microelectromechanical system (MEMS), a passive element, or a combination thereof.

In the following embodiments, ordinal numbers such as "first," "second," etc. may be used for the purpose of distinguishing one element from other elements, not a limited sense. Terms that are not described using "first," "second," etc., in the specification, may still be referred to as "first" or "second" in a claim. In addition, a term that is referenced with a particular ordinal number (e.g., "first" in a particular claim) may be referenced elsewhere without an ordinal number or with a different ordinal number (e.g., "second" in the specification or another claim).

Items described in the singular herein may be provided in plural, as can be seen, for example, in the drawings. Thus, the description of a single item that is provided in plural should be understood to be applicable to the remaining plurality of items unless context indicates otherwise.

Throughout the specification, when a component is described as "including" a particular element or group of elements, it is to be understood that the component is formed of only the element or the group of elements, or the element or group of elements may be combined with additional elements to form the component, unless the context indicates otherwise.

It will be understood that when an element is referred to as being "connected" to or "on" another element, it can be directly connected to or on the other element or intervening elements may be present.

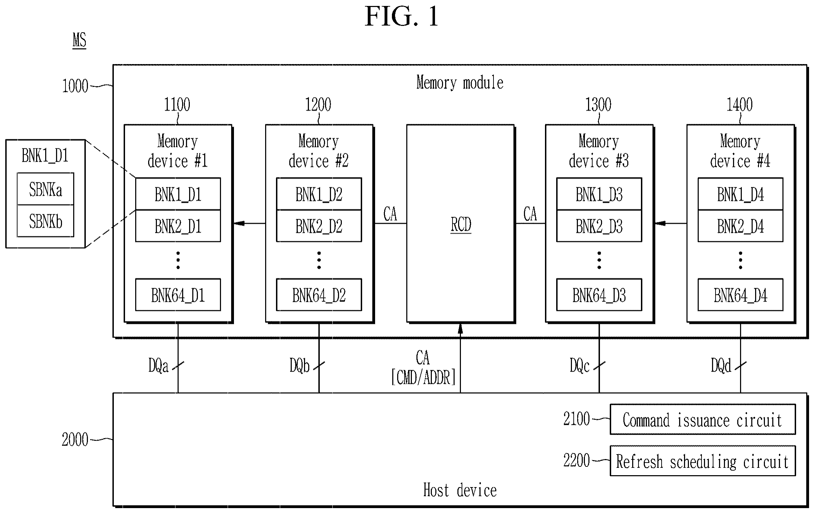

FIG. 1 is a block diagram showing a memory system according to an embodiment of the present disclosure. Referring to FIG. 1, a memory system MS may include a memory module 1000 and a host device 2000. The memory module 1000 may include first to fourth memory devices 1100 to 1400 and a register clock driver RCD. The host device 2000 may include a command issuance circuit 2100 and a refresh scheduling circuit 2200.

In an embodiment, the memory module 1000 may have a form factor of a Dual In-line Memory Module (DIMM). However, the scope of the present disclosure is not limited thereto, and the memory module 1000 may have various types of form factors, such as a compression attached memory module (CAMM).

In an embodiment, the host device 2000 may include one of various types of processors, such as a central processing unit (CPU), a graphic processing unit (GPU), and the like.

In an embodiment, each of the first to fourth memory devices 1100 to 1400 may be implemented as a volatile memory device such as a dynamic random access memory (DRAM) device.

The first to fourth memory devices 1100 to 1400 may transmit data to or receive data from the host device 2000 through a plurality of data pins DQ. Each of the first to fourth memory devices 1100 to 1400 may be connected to the host device 2000 through a subset of the plurality of data pins DQ. For example, the first memory device 1100 may communicate with the host device 2000 via a first plurality of data pins DQa, the second memory device 1200 may communicate with the host device 2000 via a second plurality of data pins DQb, the third memory device 1300 may communicate with the host device 2000 via a third plurality of data pins DQc, and the fourth memory device 1400 may communicate with the host device 2000 via a fourth plurality of data pins DQd. The memory module 1000 may provide a data bus width equivalent to the total number of data pins across the first to fourth memory devices 1100 to 1400 (e.g., the sum of DQa, DQb, DQc and DQd). For example, when each of the first to fourth memory devices 1100 to 1400 has eight data pins, the memory module 1000 may provide 32-bits-wide data bus. The data pins DQ may be connected to the host device 2000 via a plurality of data lines.

Each of the first to fourth memory devices 1100 to 1400 may include a plurality of memory banks BNKs. For example, the first memory device 1100 may include memory banks BNK1_D1 to BNK64_D1, the second memory device 1200 may include memory banks BNK1_D2 to BNK64_D2, the third memory device 1300 may include memory banks BNK1_D3 to BNK64_D3, and the fourth memory device 1400 may include memory banks BNK1_D4 to BNK64_D4. Each memory bank BNK may include a plurality of memory cells.

For a more concise explanation, a memory module 1000, according to an embodiment, may include four memory devices, and each memory device may include sixty-four memory banks. However, the scope of the present disclosure is not limited to this example number of memory devices included in the memory module 1000 nor to this example number of memory banks included in each memory device.

In an embodiment, the first to fourth memory devices 1100 to 1400 may form a single memory rank, in which the first to fourth memory devices 1100 to 1400 may be connected to command/address signal lines and a chip select signal line and share a command/address signal CA and a chip select signal CS received through the command/address signal lines and the chip select signal line. Therefore, the first to fourth memory devices 1100 to 1400 may perform an operation simultaneously in response to an operation command decoded from the command/address signal CA and the chip select signal CS. Although other ranks may share the command/address signal CA, the ranks may not perform the operation because corresponding chip select signals CS for the ranks are not selected.

Each memory bank BNK may include a plurality of memory cells, and each memory cell may store data in a form of electrical charge stored in a capacitor. Because an amount of charge stored in each of the plurality of memory cells may gradually dissipates as time progresses, data stored in the plurality of memory cells of the memory bank BNK may deteriorate as time progresses. To maintain data integrity, each memory device may periodically perform refresh operations and restore the electrical charge stored in each of the plurality of memory cells.

Each of the plurality of memory banks BNKs included in the memory module 1000 may include two or more sub banks SBNKs. For example, the memory bank BNK1_D1 may include a first sub-bank SBNKa and a second sub-bank SBNKb. According to an embodiment, each of the plurality of memory banks BNKs included in the memory module 1000 may include two sub-banks SBNKs. However, the scope of the present disclosure is not limited to the number of sub-banks SBNKs included in each of the plurality of memory banks BNKs.

Each of the two sub-banks SBNKs included in each of the plurality of memory banks BNKs may include a plurality of word lines which are distinct from one another. For example, the first sub-bank SBNKa may be connected to a first plurality of word lines, and the second sub-bank SBNKb may be connected to a second plurality of word lines. So, different operations may be performed simultaneously on the first and second sub-banks SBNKs.

In an embodiment, the number of word lines connected to each of the two sub-banks included in a single memory bank BNK may be equal.

In an embodiment, the number of memory cells included in each of the two sub-banks included in a single memory bank BNK may be equal.

The command issuance circuit 2100 may control the memory module 1000 by issuing various types of commands CMDs. For example, the command issuance circuit 2100 may issue various types of commands CMD, such as an activate command, a precharge command, a read command, a write command, a regular refresh command (REF_REG), a hidden refresh command (HR), a mode register read command (MRR), a mode register write command (MRW), and the like. The command issuance circuit 2100 may issue the various types of commands CMD and address ADDR corresponding thereto, in form of the command/address signals CA.

The register clock driver RCD may receive the command/address signal CA from the host device 2000. The register clock driver RCD may broadcast the command/address signal CA to the first to fourth memory devices 1100 to 1400. That is, the first to fourth memory devices 1100 to 1400 may share the command/address signal CA.

Upon receiving a command/address signal including a bank address and a bank group address, each of the first to fourth memory devices 1100 to 1400 may access a corresponding memory bank among the plurality of memory banks BNKs of each of the first to fourth memory devices 1100 to 1400, and perform an operation on memory banks identified with a combination of the bank address (e.g., BA) and bank group address (e.g., BGA) included in the command/address signal CA. For example, the first memory device 1100 may access a memory bank BNK1_D1 among the memory banks BNK1_D1 to BNK64_D1 based on the bank address BA and the bank group address BGA. Each bank group, identified by the bank group address, may include several memory banks, and each memory bank within one bank group may be identified by the bank address. For example, the first memory device 1100 may include four bank groups (e.g., BNK1_D1 to BNK16_D1, BNK17_D1 to BNK32_D1, BNK33_D1 to BNK48_D1, and BNK49_D1 to BNK64_D1), and each bank group include sixteen memory banks. In this configuration, the bank group address may include two-bits of address information and the bank address may include four-bits of address information.

Each memory bank of the first to fourth memory devices 1100 to 1400 having the same bank index (e.g., a bank number, or a bank identifier) may be identified with the same combination of bank address and bank group address. For example, the first memory banks of the first to fourth memory devices 1100 to 1400 BNK1_D1 to BNK1_D4 having bank index '1' may be identified with an identical bank address and bank group address (e.g., a combination of bank address '0' and bank group '0'), and the second memory banks of the first to fourth memory devices 1100 to 1400 BNK2_D1 to BNK2_D4 having bank index '2' may be identified with an identical bank address and bank group address (e.g., a combination of bank address '1' and bank group address '0').

Accordingly, memory banks of the same bank index may be controlled simultaneously. For example, each of the memory banks BNK1_D1 to BNK1_D4 (i.e., memory banks referenced by "BNK1") may be accessed simultaneously by the host device 2000.

More specifically, when a memory bank BNK included in the first memory device 1100 is accessed by the host device 2000, memory banks BNK of the second to fourth memory devices 1200 to 1400 having the same bank index may be accessed simultaneously. For example, when the memory bank BNK1_D1 is accessed to perform an operation in response to a command from the host device 2000, the memory banks BNK1_D2 to BNK1_D4 may also be accessed to perform the same operation as the memory bank BNK1_D1.

The command issuance circuit 2100 may issue a refresh command to refresh the memory banks BNK included in the memory module 1000. The refresh command may be a regular refresh command REF_REG or a hidden refresh command HR. In an example embodiment, the command issuance circuit 2100 may issue the regular refresh command REF_REG for performing a refresh operation on the memory bank BNK1_D1. Because the regular refresh command REF_REG is performed on memory banks having the same bank index, the refresh operations are also performed on the memory banks BNK1_D2 to BNK1_D4 of the second to fourth memory devices 1200 to 1400 in response to the regular refresh command issued by the command issuance circuit 2100. Because the memory banks BNK1_D2 to BNK1_D4 share the command/address signal CA with the memory bank BNK1_D1, in response to the regular refresh command REF_REG issued by the command issuance circuit 2100, the memory banks BNK1_D2 to BNK1_D4 are refreshed simultaneously with the memory bank BNK1_D1.

The command issuance circuit 2100 may issue the regular refresh command REF_REG. For example, the command issuance circuit 2100 may issue the regular refresh command REF_REG indicating a refresh operation for the memory bank BNK1_D1. The regular refresh command REF_REG may be an all-bank refresh command in which all memory banks are refreshed simultaneously in response to the regular refresh command REF_REG. Alternatively, the regular refresh command REF_REG may be a per-bank refresh command in which memory banks identified in the per-bank refresh command are refreshed simultaneously. Although the present disclosure describes the per-bank refresh command as the regular refresh command REF_REG, it also may be applied to the case where the regular refresh command REF_REG is the all-bank refresh command. The first memory device 1100 may perform the regular refresh operation at different locations of the memory bank BNK1_D1 in response to the regular refresh command REF_REG. For example, the first memory device 1100 may perform the regular refresh operation for the first sub-bank SBNKa and the second sub-bank SBNKb in response to the regular refresh command REF_REG.

A command issuance circuit 2100 may access one of the first sub-bank SBNKa and the second sub-bank SBNKb and perform a hidden refresh operation for the remainder by issuing the hidden refresh command HR. For example, the first memory device 1100 may activate the first sub-bank SBNKa and perform a hidden refresh operation for the second sub-bank SBNKb in response to a hidden refresh command HR for the first sub-bank SBNKa (e.g., a hidden refresh command HR including a row address for a word line connected to the first sub-bank SBNKa). Conversely, the first memory device 1100 may activate the second sub-bank SBNKb and perform a hidden refresh operation for the first sub-bank SBNKa in response to a hidden refresh command HR for the second sub-bank SBNKb (e.g., a hidden refresh command HR including a row address for a word line connected to the second sub-bank SBNKb). Therefore, while activating a specific sub-bank SBNK, the first memory device 1100 may perform a hidden refresh operation for another sub-bank SBNK in the background. In this case, even if the hidden refresh operation is performed for a specific sub-bank, there may be no restriction on the input/output operation of the first memory device 1100.

For a more concise explanation, it is assumed below that each memory device performs an activation operation and a hidden refresh operation in response to the hidden refresh command HR. However, the scope of the present disclosure is not limited thereto, and each memory device may be implemented to perform various types of operations, such as a read operation, a write operation, etc., together with a hidden refresh operation in response to the hidden refresh command HR.

The command issuance circuit 2100 may issue the regular refresh command REF_REG for the memory bank BNK1_D1 at each regular refresh period. The first memory device 1100 may refresh some memory cells of the memory bank BNK1_D1 in response to the regular refresh command REF_REG. Sequentially and periodically, the command issuance circuit 2100 may issue the regular refresh command REF_REG to refresh all of memory cells in the memory bank BNK1_D1 to maintain the integrity of data stored in the memory bank BNK1_D1. Likewise, the command issuance circuit 2100 may issue the regular refresh command REF_REG to refresh all of memory cells of the first to fourth memory devices 1100 to 1400 within data retention time of the memory cells to maintain the integrity of data stored in the plurality of memory banks BNKs of the first to fourth memory devices 1100 to 1400.

The refresh scheduling circuit 2200 may schedule time points at which the command issuance circuit 2100 issues the regular refresh command REF_REG. For example, the refresh scheduling circuit 2200 may poll skip allowance information (SAI) from the memory module 1000 to determine whether the issuance of one or more regular refresh command REF_REG may be skipped. The refresh scheduling circuit 2200 may control issuance number of regular refresh commands REF_REG and time points at which the command issuance circuit 2100 issues a regular refresh commands REF_REG based on the polled skip allowance information SAI.

For example, the command issuance circuit 2100 may skip an issuance of the regular refresh command REF_REG during a specific regular refresh period under the control of the refresh scheduling circuit 2200. That is, in the specific regular refresh period, the command issuance circuit 2100 may skip issuing the regular refresh command REF_REG under the control of the refresh scheduling circuit 2200. As the number of regular refresh operations is reduced, the command issuance circuit 2100 may issue additional operation commands instead of the skipped regular refresh command REF_REG. Accordingly, the operating performance of the memory system MS may be improved. For example, when the command issuance circuit 2100 issues an operation command rather than a regular refresh command REF_REG, the first to fourth memory devices 1100 to 1400 may not perform the regular refresh operation, and the host device 2000 may send an input/output operation command (e.g., request) for the first to fourth memory devices 1100 to 1400 to perform the input/output operation. The manner in which the command issuance circuit 2100 skips issuing a regular refresh command REF_REG under the control of the refresh scheduling circuit 2200 will be specifically described below.

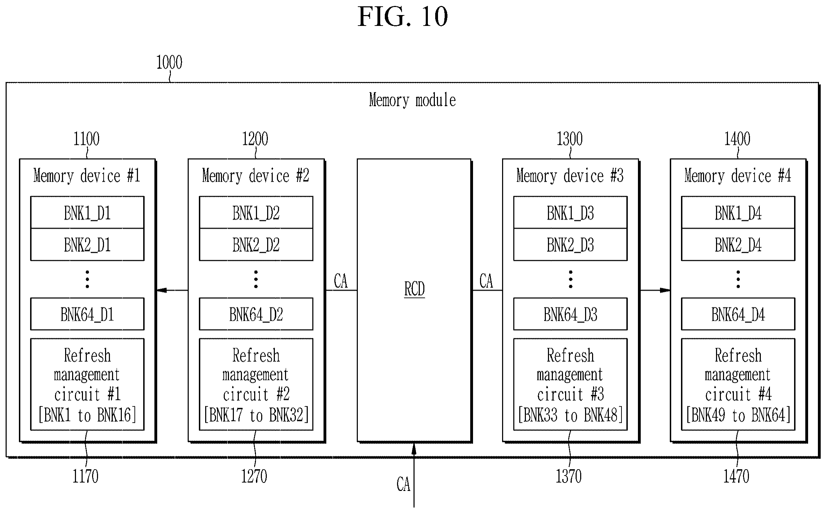

In an embodiment, the refresh scheduling circuit 2200 may poll skip allowance information SAI from a plurality of memory devices (e.g., the first to fourth memory devices 1100 to 1400). The procedure of polling the skip allowance information SAI from the plurality of memory devices by the refresh scheduling circuit 2200 is described in more detail with reference to FIGS. 10 to 17.

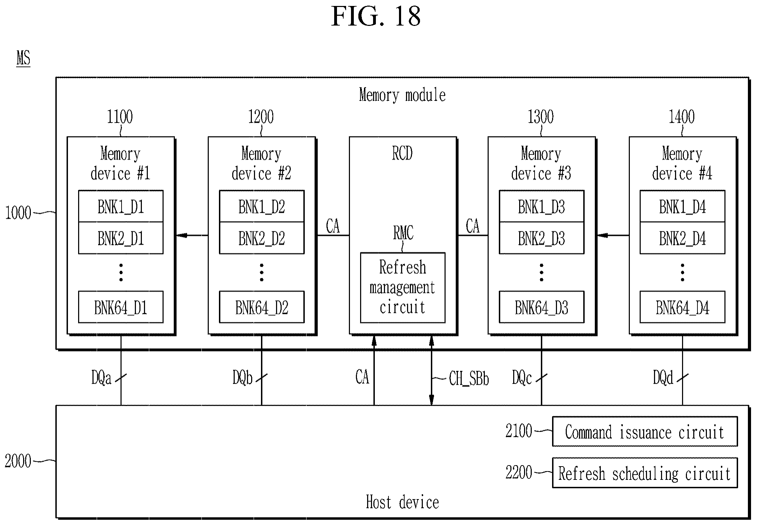

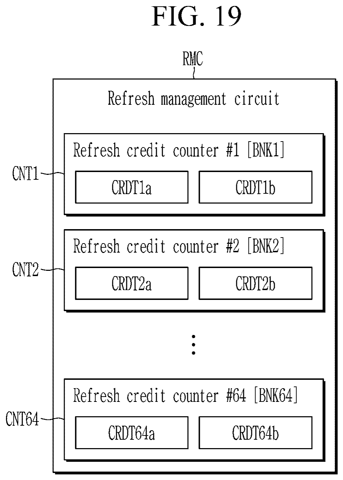

In an embodiment, the refresh scheduling circuit 2200 may poll skip allowance information SAI from the register clock driver RCD. The procedure of polling the skip allowance information SAI from the register clock driver RCD by refresh scheduling circuit 2200 is described in more detail with reference to FIGS. 18 and 19.

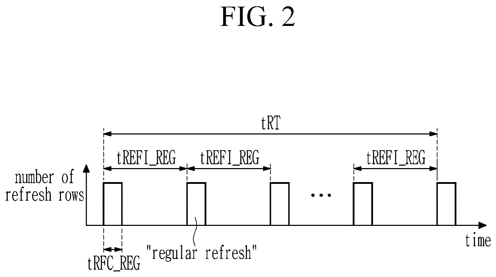

FIG. 2 is a diagram showing how a regular refresh operation is performed for one memory bank. Below, for a more concise explanation, the regular refresh operation performed for the memory bank BNK1_D1 is described with reference to FIGS. 1 and 2. The horizontal axis of FIG. 2 may represent time, and the vertical axis may represent the number of memory cell rows that the first memory device 1100 refreshes per unit time.

The first memory device 1100 may perform a regular refresh operation during a regular refresh consumption time tRFC_REG in response to the regular refresh command REF_REG. For example, the first memory device 1100 may perform a refresh operation on some of the plurality of memory cells included in the memory bank BNK1_D1 in response to the regular refresh command REF_REG. Therefore, in order to refresh all memory cells included in the memory bank BNK1_D1, the first memory device 1100 may have to perform the regular refresh operations a plurality of times.

In an embodiment, during the regular refresh consumption time tRFC_REG for the memory bank BNK1_D1, the host device 2000 may not be able to access the memory bank BNK1_D1. For example, during the regular refresh consumption time tRFC_REG for the memory bank BNK1_D1, other commands to the memory bank BNK1_D1 of the host device 2000 issued during the regular refresh consumption time tRFC_REG may be treated as invalid commands. Therefore, during the regular refresh consumption time tRFC_REG for the memory bank BNK1_D1, the input/output operation for the memory bank BNK1_D1 may be restricted. and thus the input/output performance of the memory module 1000 may be affected by the regular refresh consumption time tRFC_REG and the number of regular refresh commands REF_REG within a regular refresh period.

The time during which the integrity of data stored in a memory cell is guaranteed without a refresh operation may be referred to as a retention time tRT. To ensure the integrity of data stored in all memory cells of the memory bank BNK1_D1, each memory cell may be refreshed at least once within the retention time tRT.

In an embodiment, the first memory device 1100 may refresh different combinations of memory cell rows whenever it performs a regular refresh operation within one retention time tRT. For example, the command issuance circuit 2100 may issue the first and second regular refresh commands for the memory bank BNK1_D1 within one retention time tRT. In this case, the first memory device 1100 may refresh a first plurality of memory cell rows in response to the first regular refresh command, and may refresh the second plurality of memory cell rows that are different from the first plurality of memory cell rows in response to the second regular refresh command.

To ensure the integrity of data stored in all memory cells of the memory bank BNK1_D1, the command issuance circuit 2100 may issue a predetermined number of regular refresh commands REF_REG during the retention time tRT. For example, the command issuance circuit 2100 may issue up to 8192 regular refresh commands REF_REG for the first to fourth memory devices 1100 to 1400during the single retention time tRT. However, the scope of the present disclosure is not limited to the number of regular refresh commands REF_REG issued by the command issuance circuit 2100 during the single retention time tRT.

To issue the predetermined number of regular refresh commands REF_REG during the single retention time tRT, the command issuance circuit 2100 may issue a regular refresh command REF_REG with a regular refresh interval tREFI_REG. For example, the command issuance circuit 2100 may issue a regular refresh command REF_REG with a time interval corresponding to the regular refresh interval tREFI_REG.

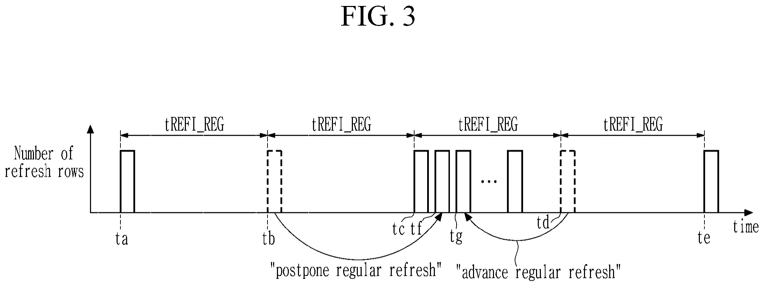

FIG. 3 is a diagram showing the operation of the refresh scheduling circuit of FIG. 1. Hereinafter, for a more concise explanation, an embodiment of adjusting the timing at which a refresh scheduling circuit 2200 issues the regular refresh command REF_REG to the memory bank BNK1_D1 of the command issuance circuit 2100 is representatively described with reference to FIGS. 1 to 3. The horizontal axis of FIG. 3 may represent time, and the vertical axis may represent the number of memory cell rows that the first memory device 1100 refreshes per unit time.

Referring to FIGS. 1 to 3, the first to fourth memory devices 1100 to 1400 may start a regular refresh operation at a first time point ta, a second time point tb, a third time point tc, a fourth time point td, and a fifth time point te. As described above with reference to FIG. 2, the command issuance circuit 2100 may, in principle, issue a regular refresh command REF_REG at each of the first time point ta, the second time point tb, the third time point tc, the fourth time point td, and the fifth time point te.

The refresh scheduling circuit 2200 may advance or postpone the issuance of the regular refresh command REF_REG by the command issuance circuit 2100 within a predetermined number of times. For example, instead of issuing the regular refresh command REF_REG at the second time point tb, the command issuance circuit 2100 may issue the regular refresh command REF_REG at the sixth time point tf between the third time point tc and the fourth time point td. That is, the host device 2000 may postpone issuing a regular refresh command REF_REG for the second time point tb to the sixth time point tf. In another example, instead of issuing a regular refresh command REF_REG at the fourth time point td, the host device 2000 may issue a regular refresh command REF_REG at the seventh time point tg between the third time point tc and the fourth time point td. That is, the host device 2000 may advance the issuance of the regular refresh command REF_REG for the fourth time point td to the seventh time point tg. Because the timing at which the command issuance circuit 2100 issues a regular refresh command REF_REG to the memory bank BNK1_D1 may be flexibly adjusted, the operation of the memory system MS may be less restricted by the refresh operations, and the operating efficiency of the memory system MS may be improved.

In an embodiment, the predetermined number of times that the command issuance circuit 2100 may advance or postpone issuing a regular refresh command REF_REG to the memory bank BNK1_D1 may be referred to as a refresh fluctuation threshold.

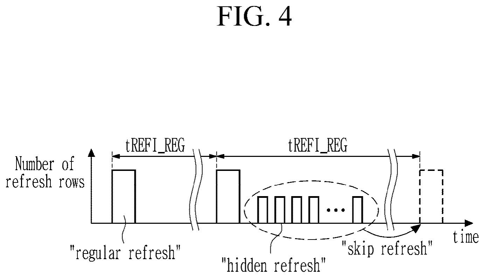

FIG. 4 is a diagram showing the operation of the refresh scheduling circuit of FIG. 1. Below, for a more concise explanation, the operation of the refresh scheduling circuit 2200 when a hidden refresh operation is performed for the memory bank BNK1_D1 is representatively described with reference to FIGS. 1 to 4. The horizontal axis of FIG. 4 may represent time, and the vertical axis may represent the number of memory cell rows that the first memory device 1100 refreshes per unit time.

The command issuance circuit 2100 may issue the plurality of hidden refresh commands HR for the memory bank BNK1_D1 within one regular refresh interval tREFI_REG. The first memory device 1100 may perform a hidden refresh operation in response to each of the plurality of hidden refresh commands HR. For example, the first memory device 1100 may perform a hidden refresh operation for the second sub-bank SBNKb in response to a hidden refresh command HR for the first sub-bank SBNKa, and may perform a hidden refresh operation for the first sub-bank SBNKa in response to a hidden refresh command HR for the second sub-bank SBNKb.

In an embodiment, the first memory device 1100 may perform a plurality of hidden refresh operations within one regular refresh interval tREFI_REG, and each of the hidden refresh operations may be performed on a different group of memory cell rows. For example, the command issuance circuit 2100 may issue a first hidden refresh command and a second hidden refresh command within one regular refresh interval tREFI_REG. In this case, the first memory device 1100 may refresh a first group of memory cell rows in response to the first hidden refresh command, and may refresh a second group of memory cell rows which are different from the first group in response to the second hidden refresh command.

A number of memory cell rows refreshed when the first memory device 1100 performs one hidden refresh operation may be less than a number of memory cell rows refreshed when the first memory device 1100 performs one regular refresh operation. Accordingly, the first memory device 1100 may perform the hidden refresh operation a plurality of times to refresh the memory cell rows corresponding to one regular refresh operation. For example, the first memory device 1100 may perform hidden refresh operations a plurality of times to refresh memory cell rows that are to be refreshed through a regular refresh operation in advance. Accordingly, a portion of regular refresh operations to be performed in the first memory device 1100 may be replaced with a plurality of hidden refresh operations.

When the hidden refresh operation for the first sub-bank SBNKa and the hidden refresh operation for the second sub-bank SBNKb are performed a sufficient number of times to substitute for one or more regular refresh operations, the refresh scheduling circuit 2200 may control the command issuance circuit 2100 to skip issuance of the regular refresh command REF_REG. For example, if the hidden refresh operation for the first sub-bank SBNKa and the hidden refresh operation for the second sub-bank SBNKb are performed sufficiently to replace the regular refresh operation for the memory bank BNK1_D1, the command issuance circuit 2100 may skip issuing the regular refresh command REF_REG.

According to an embodiment, a hidden refresh operation may be performed in the background in one sub-bank (e.g., the first sub-bank SBNKa) while an operation (e.g., an activation operation) being performed in the other sub-bank (e.g., the second sub-bank SBNKb), and a regular refresh operation for one memory bank may be replaced with a plurality of hidden refresh operations for the sub-banks of the memory bank. Because the input/output performance degradation of the memory module 1000 due to the regular refresh consumption time tRFC_REG may be reduced, the operating efficiency and operating performance of the memory system MS may be improved.

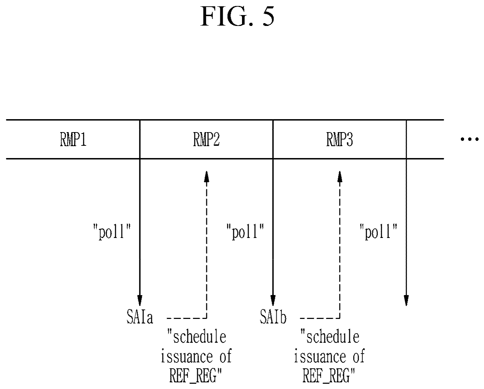

FIG. 5 is a diagram showing the operation of a memory system according to the embodiments of FIGS. 3 and 4. Hereinafter, for a more concise explanation, the operation of a refresh scheduling circuit 2200 that determines the issuance schedule of regular refresh commands REF_REG for the memory bank BNK1_D1 is representatively described with reference to FIGS. 1 to 3.

The refresh scheduling circuit 2200 may manage the number of issuance times of the regular refresh commands REF_REG for the memory bank BNK1_D1 during a refresh management period RMP. For example, the refresh scheduling circuit 2200 may determine the number of issuance times of the regular refresh command REF_REG for each of the first to third refresh management periods RMP1 to RMP3 separately (e.g., independently).

In an embodiment, the length of the refresh management period RMP may be determined based on the refresh fluctuation threshold and the regular refresh interval tREFI_REG. For example, the length of each of the first to third refresh management periods RMP1 to RMP3 may be determined by a product of the refresh fluctuation threshold and the regular refresh interval tREFI_REG. However, the scope of the present disclosure is not limited thereto.

In an embodiment, the number of times that the command issuance circuit 2100 has to issue the regular refresh command REF_REG to the memory bank BNK1_D1 during one refresh management period RMP may be referred to as a standard refresh number. For example, the standard refresh number may correspond to the refresh management period RMP divided by the regular refresh interval tREFI_REG.

In an embodiment, the refresh management periods RMP may be sequential. For example, the end time point of the first refresh management period RMP1 may be the start time point of the second refresh management period RMP2.

In an embodiment, the time point where each refresh management period RMP ends may be referred to as a management criteria time point (tmc).

A number of regular refresh operations for the memory bank BNK1_D1 that have to be performed in each refresh management period RMP to ensure integrity of data stored in the memory bank BNK1_D1 may vary according to a number of regular refresh operations and hidden refresh operations performed for the memory bank BNK1_D1 in a previous refresh management period. For example, if number of regular refresh operations and hidden refresh operations which performed for the memory bank BNK1_D1 during the first refresh management period RMP1 are large, the integrity of data stored in the memory bank BNK1_D1 may be guaranteed even if a number of regular refresh operations performed for the memory bank BNK1_D1 is relatively small during the second refresh management period RMP2. If a refresh operation to be performed in the second refresh management period RMP2 has been performed in advance in the first refresh management period RMP1, the integrity of data stored in the memory bank BNK1_D1 may be guaranteed even if only a smaller number of refresh operations are performed in the second refresh management period RMP2.

Accordingly, the refresh scheduling circuit 2200 may determine how many times the command issuance circuit 2100 issues regular refresh commands REF_REG for the memory bank BNK1_D1 in each refresh management period RMP based on whether the memory bank BNK1_D1 has been over-refreshed in a preceding refresh management period RMP corresponding to the refresh management period RMP.

More specifically, the refresh scheduling circuit 2200 may poll the first skip allowance information SAla from the memory module 1000. The first skip allowance information SAla may indicate how much the memory bank BNK1_D1 has been refreshed more than necessary in the first refresh management period RMP1. The refresh scheduling circuit 2200 may schedule the issuance of regular refresh commands REF_REG for the memory bank BNK1_D1 of the second refresh management period RMP2 based on the first skip allowance information SAla. For example, the refresh scheduling circuit 2200 may determine how many times of the regular refresh command REF_REG for the memory bank BNK1_D1 may be skipped in the second refresh management period RMP2 based on the first skip allowance information SAla.

In an embodiment, the refresh scheduling circuit 2200 may poll the first skip allowance information SAla at a management criteria time point between a first refresh management period RMP1 and a second refresh management period RMP2, or within the second refresh management period RMP2. However, the scope of the present disclosure is not limited to a specific time point at which the host device 2000 polls skip allowance information SAI.

Similarly, the refresh scheduling circuit 2200 may poll a second skip allowance information SAlb indicating how much of a refresh operation has been performed for the memory bank BNK1_D1 in the second refresh management period RMP2; and schedule issuance of regular refresh commands REF_REG for the memory bank BNK1_D1 in a third refresh management period RMP3 based on the second skip allowance information SAlb.

In response to refresh scheduling of the refresh scheduling circuit 2200, the refresh scheduling circuit 2200 may issue regular refresh commands REF_REG in a subsequent refresh management period RMP, where the refresh scheduling may be performed based on the polling skip allowance information SAI indicating how many refresh operations have been performed for the memory bank BNK1_D1 in recent refresh management period RMP from the memory module 1000.

According to an embodiment, the memory module 1000 may manage a number of refresh operations including the regular refresh operations and hidden refresh operations performed for each memory bank BNK, and may generate skip allowance information SAI based thereon. Due to the skip allowance information SAI, the refresh scheduling circuit 2200 may determine how many regular refresh commands REF_REG for each memory bank BNK can be skipped, even if the refresh scheduling circuit 2200 itself does not count the number of refresh operations, including the regular refresh operations and hidden refresh operations, performed for each memory bank BNK.

In an embodiment, the memory device may perform the hidden refresh operation, in response to the hidden refresh command HR, which is similar to an activation command in that both commands activate a word line. For example, the command issuance circuit 2100 may issue a hidden refresh command HR based on a command/address signal CA the same as the activation command. Alternatively, each memory device may be implemented to always process such command/address signals CA as hidden refresh commands HR, or to process them as hidden refresh commands HR only in certain situations. In either case, it may be difficult for the host device 2000 to determine how many times of hidden refresh operations has been performed for each memory bank BNK. According to an embodiment of the present disclosure, because the host device 2000 may poll the skip allowance information SAI from the memory module 1000, the host device 2000 may schedule the issuance of regular refresh commands REF_REG and hidden refresh commands HR more efficiently. However, the scope of the present disclosure is not limited to the specific configuration of the command/address signal CA corresponding to the hidden refresh command HR. For example, the command issuance circuit 2100 may issue the hidden refresh command HR based on command/address signal CA different from the activation command.

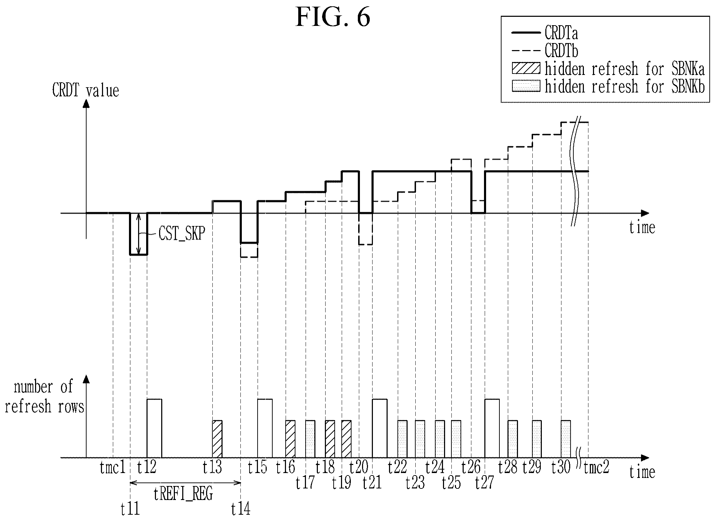

FIGS. 6 to 10 are drawings exemplarily showing how a memory module generates skip allowance information according to the embodiment of FIG. 5. Hereinafter, with reference to FIGS. 1 to 10, an exemplary embodiment in which a memory module 1000 generates skip allowance information SAI for the memory bank BNK1_D1 will be representatively described.

Referring to FIGS. 1 to 6, the memory module 1000 may manage refresh credit counts CRDT for the memory bank BNK1_D1. For example, the memory module 1000 may manage a first refresh credit count CRDTa for the first sub-bank SBNKa and a second refresh credit count CRDTb for the second sub-bank SBNKb. The horizontal axis of FIG. 6 may represent time, and the vertical axis may represent the value of a refresh credit count CRDT and the number of memory cell rows refreshed per unit time.

Below, the operation of the memory module 1000 during a refresh management period RMP between a first management criteria time point tmc1 and a second management criteria time point tmc2 is described. For a more concise explanation, the first refresh credit count CRDTa and the second refresh credit count CRDTb prior to the first management criteria time point tmc1 are assumed to be '0'.

A regular refresh period may begin at the eleventh time point t11, the fourteenth time point t14, the twentieth time point t20, and the twenty-sixth time point t26, respectively. For example, the time interval between the eleventh time point t11 and the fourteenth time point t14may be a regular refresh interval tREFI_REG.

The memory module 1000 may decrement the first refresh credit count CRDTa and the second refresh credit count CRDTb by the skip cost CST_SKP at each regular refresh period. For example, the memory module 1000 may decrement the first refresh credit count CRDTa and the second refresh credit count CRDTb by the skip cost CST_SKP at the eleventh time point t11, the fourteenth time point t14, the twentieth time point t20, and the twenty-sixth time point t26.

The memory module 1000 may increment the first refresh credit count CRDTa and the second refresh credit count CRDTb by the skip cost CST_SKP whenever the regular refresh command REF_REG for the memory bank BNK1_D1 is received. For example, the memory module 1000 may receive the regular refresh command REF_REG for the memory bank BNK1_D1 from the host device 2000 at a twelfth time point t12, a fifteenth time point t15, a twenty-first time point t21, and a twenty-seventh time point t27. In this case, the memory module 1000 may increment the first refresh credit count CRDTa and the second refresh credit count CRDTb by the skip cost CST_SKP at the twelfth time point t12, the fifteenth time point t15, the twenty-first time point t21, and the twenty-seventh time point t27.

The memory module 1000 may increase the first refresh credit count CRDTa each time it performs a hidden refresh operation for the first sub bank SBNKa. For example, the host device 2000 may issue a hidden refresh command HR for the second sub-bank SBNKb at the thirteenth, sixteenth, eighteenth, and nineteenth time points t13, t16, t18, and t19. In this case, each at the thirteenth, sixteenth, eighteenth, and nineteenth time points t13, t16, t18, and t19, the memory module 1000 may perform a hidden refresh operation for the first sub bank SBNKa and increase the first refresh credit count CRDTa by '1'.

The memory module 1000 may increase the second refresh credit count CRDTb each time it performs a hidden refresh operation for the second sub bank SBNKb. For example, the host device 2000 may issue a hidden refresh command HR for the first sub-bank SBNKa at the seventeenth, twenty-second, twenty-third, twenty-fourth, twenty-fifth, twenty-eighth, twenty-ninth, and thirtieth time points t17, t22, t23, t24, t25, t28, t29, and t30. In this case, each at the seventeenth, twenty-second, twenty-third, twenty-fourth, twenty-fifth, twenty-eighth, twenty-ninth, and thirtieth time points t17, t22, t23, t24, t25, t28, t29, and t30, the memory module 1000 may perform a hidden refresh operation on the second sub-bank SBNKb and increase the second refresh credit count CRDTb by '1'.

For example, at the end of a refresh management period RMP (e.g., the second management criteria time point tmc2), the first refresh credit count CRDTa may be '4' and the second refresh credit count CRDTb may be '8'.

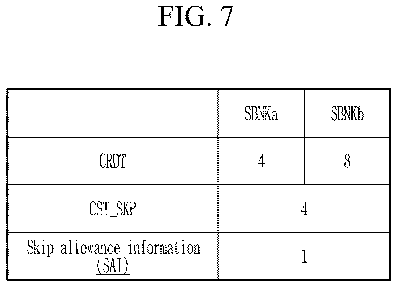

Referring to FIG. 7, the memory module 1000 may generate skip allowance information SAI based on the first and second refresh credit counts CRDTa, CRDTb at the end of the refresh management period RMP. For example, the memory module 1000 may generate skip allowance information SAI based on the first and second refresh credit counts CRDTa, CRDTb at the second management criteria time point tmc2.

The skip allowance information SAI may indicate how many regular refresh operations for the memory bank BNK1_D1 can be skipped during the next refresh management period RMP. More specifically, the skip allowance information SAI may indicate that the memory bank BNK1_D1 has been over-refreshed during the refresh management period RMP between the first and second management criteria time points tmc1 and tmc2, and the regular refresh operations corresponding to the skip allowance information SAI may be skipped. For example, the memory module 1000 may determine the skip allowance information SAI as an integer quotient obtained by dividing a smaller value among the first and second refresh credit counts CRDTa, CRDTb by the skip cost CST_SKP. More specifically, the memory module 1000 may determine the skip allowance information SAI as '1', which is an integer quotient obtained by dividing a smaller value among the first and second refresh credit counts CRDTa, CRDTb, in this case, the first refresh credit count CRDTa of '4', by the skip cost CST_SKP of '4'. During the next refresh management period RMP, the host device 2000 may poll for skip allowance information SAI of '1', and may schedule issuance of regular refresh commands REF_REG of the next refresh management period RMP after the second management criteria time point tmc2 based on the skip allowance information SAI.

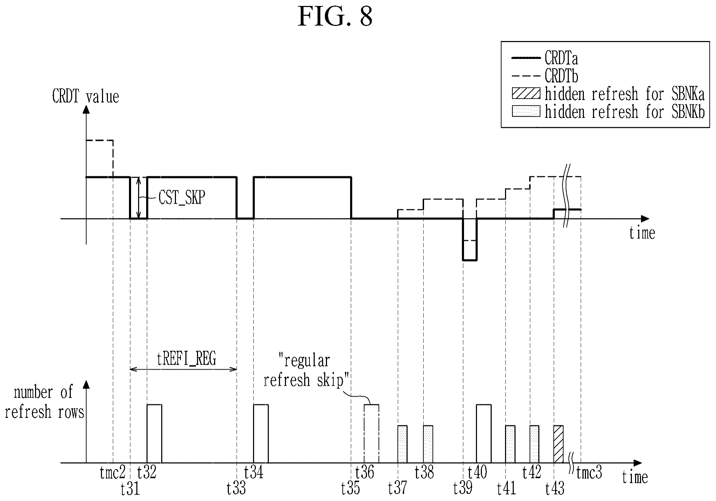

Referring to FIG. 8, the memory module 1000 may update the first and second refresh credit counts CRDTa, CRDTb at an end of a refresh management period RMP. For example, the memory module 1000 may update the first and second refresh credit counts CRDTa, CRDTb at the second management criteria time point tmc2 reflecting the first and second refresh credit counts CRDTa, CRDTb counted between the first management criteria time point tmc1 and the second management criteria time point tmc2. Below, the operation of the memory module 1000 during a refresh management period RMP between the second management criteria time point tmc2 and the third management criteria time point tmc3 will be exemplarily described. The horizontal axis of FIG. 8 may represent time, and the vertical axis may represent the value of a refresh credit count CRDT and the number of memory cell rows refreshed per unit time.

In an embodiment, the memory module 1000 may update the first and second refresh credit counts CRDTa, CRDTb by the product of the skip allowance information SAI and the skip cost CST_SKP generated based on a previous refresh management period RMP (e.g., a time period between the first and second management criteria time points tmc1 and tmc2). For example, the memory module 1000 may update the first and second refresh credit counts CRDTa, CRDTb to '4' (e.g., the product of the skip allowance information '1' and the skip cost '4') at the second management criteria time point tmc2. However, the scope of the present disclosure is not limited thereto, and the memory module 1000 may be implemented to maintain the first and second refresh credit counts CRDTa, CRDTb at the management criteria time point tmc to be same as the previous refresh management period RMP, or may initialize (e.g., reset to '0') the first and second refresh credit counts CRDTa, CRDTb at each management criteria time point tmc. However, for a more concise explanation below, it will be assumed that the memory module 1000 updates the first and second refresh credit counts CRDTa, CRDTb as a product of the skip allowance information SAI and the skip cost CST_SKP corresponding to the previous refresh management period RMP at each management criteria time tmc.

During the refresh management period RMP between the second management criteria time point tmc2 and the third management criteria time point tmc3, the memory module 1000 may manage the first refresh credit count CRDTa and the second refresh credit count CRDTb in a similar manner as described above with reference to FIG. 6. For example, the memory module 1000 may decrement the first and second refresh credit counts CRDTa, CRDTb by the skip cost CST_SKP at each of regular refresh intervals which are the thirty-first, thirty-third, thirty-fifth, and thirty-ninth time points t31, t33, t35, and t39, and may increment the first and second refresh credit counts CRDTa, CRDTb by the skip cost CST_SKP at the thirty-second, thirty-fourth, and fortieth time points t32, t34, and t40 when regular refresh commands REF_REG for the memory bank BNK1_D1 is received.

The memory module 1000 may increase the first refresh credit count CRDTa by '1' at a forty-third time point t43 when a hidden refresh command HR for the second sub-bank SBNKb is received (e.g., performing a hidden refresh operation for the first sub-bank SBNKa); and may increase the second refresh credit count CRDTb by '1' at thirty-seventh, thirty-eighth, forty-first, and forty-second time points t37, t38, t41, and t42 when a hidden refresh command HR for the first sub-bank SBNKa is received (e.g., performing a hidden refresh operation for the second sub-bank SBNKb).

The host device 2000 may schedule refresh operations during the refresh management period RMP between the second management criteria time point tmc2 and the third management criteria time point tmc3 based on the skip allowance information SAI generated from the first and second refresh credit counts CRDTa, CRDTb counted during the previous refresh management period RMP. For example, based on the skip allowance information SAI (e.g., '1') generated from the first and second refresh credit counts CRDTa, CRDTb during the refresh management period RMP between the first management criteria time point tmc1 and the second management criteria time point tmc2, the refresh scheduling circuit 2200 may control the command issuance circuit 2100 to skip the issuance of the regular refresh command REF_REG a number of times (e.g., '1') as indicated by the skip allowance information SAI during the refresh management period RMP between the second management criteria time point tmc2 and the third management criteria time point tmc3. More specifically, the refresh scheduling circuit 2200 may control the command issuance circuit 2100 to skip issuing the regular refresh command REF_REG at the thirty-sixth time point t36. In this case, the memory module 1000 may not receive a regular refresh command REF_REG for the memory bank BNK1_D1 at the thirty-sixth time point t36, and accordingly, the first and second refresh credit counts CRDTa, CRDTb at the thirty-sixth time point t36 may not change.

In this way, at the end of the refresh management period RMP between the first management criteria time point tmc1 and the second management criteria time point tmc2, the first refresh credit count CRDTa may be '1' and the second refresh credit count CRDTb may be '4'.

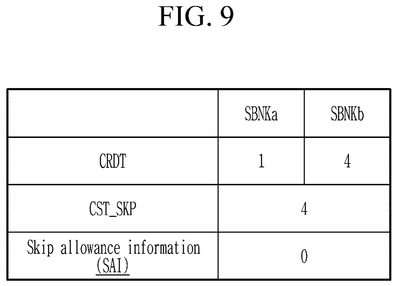

Referring to FIG. 9, the memory module 1000 may generate skip allowance information SAI based on the first and second refresh credit counts CRDTa, CRDTb counted between the second management criteria time point tmc2 and the third management criteria time point tmc3. For example, the memory module 1000 may determine skip allowance information SAI as '0', which is the integer quotient obtained by dividing a smaller value among the first and second refresh credit counts CRDTa, CRDTb, which is the first refresh credit count CRDTa of "1", by the skip cost CST_SKP '4'. In this case, the host device 2000 may poll skip allowance information SAI of '0', and may schedule issuance of regular refresh command REF_REG of refresh management period RMP after the third management criteria time point tmc3 based on the skip allowance information SAI of '0'.

For a more concise explanation, in FIGS. 6 to 10, an embodiment is described in which the integer quotient of the smaller value among the first and second refresh credit counts CRDTa, CRDTb at the end point of each refresh management period RMP divided by the skip cost CST_SKP is determined as skip allowance information SAI, but the scope of the present disclosure is not limited thereto. For example, the memory module 1000 may determine the skip allowance information SAI as a result of combining (e.g., concatenating) the first and second refresh credit counts CRDTa, CRDTb at the end of a refresh management period RMP. In this case, the host device 2000 may calculate a number of issuance times of regular refresh commands REF_REG that can be skipped in the next refresh management period RMP, by directly referring to the values of the first and second refresh credit counts CRDTa, CRDTb.

In an embodiment, the first and second refresh credit counts CRDTa, CRDTb may be managed to be greater than or equal to '0' at the end of each refresh management period RMP. For example, the host device 2000 may issue a sufficient number of regular refresh commands REF_REG and hidden refresh commands HR so that the first and second refresh credit counts CRDTa, CRDTb are greater than or equal to '0' at the end of each refresh management period RMP. In this case, sufficient number of refresh operations may be performed, and the integrity of data stored in the memory module 1000 may be guaranteed.

In an embodiment, the first and second refresh credit counts CRDTa, CRDTb may be managed not to exceed a pre-determined upper bound value (e.g., a product of the skip cost CST_SKP and the refresh fluctuation threshold). For example, the host device 2000 may control the issuance time interval of the regular refresh command REF_REG and the hidden refresh command HR so that the first and second refresh credit counts CRDTa, CRDTb remain lower than the pre-determined upper bound value. In this case, the deterioration of power efficiency and operational performance of the memory system MS due to over-refresh (e.g., excessive refresh) may be reduced.

In this way, the memory module 1000 may manage refresh credit counts CRDT for each memory bank BNK, and may provide skip allowance information SAI generated based on the refresh credit counts CRDT to the host device 2000 in response to a request from the host device 2000.

In an embodiment, the plurality of refresh credit counts CRDTs may be managed in a distributed manner by a plurality of memory devices. An embodiment in which the plurality of refresh credit counts CRDTs are managed in a distributed manner by the plurality of memory devices is described in more detail with reference to FIGS. 10 to 17 below.

In an embodiment, the plurality of refresh credit counts CRDTs may be managed by the register clock driver RCD. An embodiment in which the plurality of refresh credit counts CRDTs are managed by a register clock driver RCD is described in more detail with reference to FIGS. 18 and 19 below.

FIG. 10 is a block diagram showing how a memory module manages the plurality of refresh credit counts according to an embodiment of the present disclosure. Referring to FIGS. 1 to 10, the memory module 1000 may include first to fourth memory devices 1100 to 1400 and the register clock driver RCD. The configuration and function of the first to fourth memory devices 1100 to 1400 and the register clock driver RCD have been described above with reference to FIG. 1, so a detailed description thereof is omitted.

The first to fourth memory devices 1100 to 1400 may include first to fourth refresh management circuits 1170 to 1470, respectively. Each of the first to fourth refresh management circuits 1170 to 1470 may manage refresh operations for different memory banks BNKs. For example, each of the first to fourth refresh management circuits 1170 to 1470 may count hidden refresh operations performed for different memory banks BNKs and may generate skip allowance information SAI based on the counted number.

The first refresh management circuit 1170 may manage memory banks having bank indexes of '1' to '16' (i.e., memory banks BNK1 to BNK16). For example, the first refresh management circuit 1170 may manage refresh operations for memory banks BNK1 to BNK16 based on command/address signal CA including bank address and bank group address which indicate bank indexes of '1' to '16'.

More specifically, the first refresh management circuit 1170 may manage a refresh operation for the memory banks BNK1_D1 to BNK16_D1 based on that the command/address signal CA (more specifically, command/address signal CA indicating a hidden refresh command HR or a regular refresh command REF_REG) received by the first memory device 1100 in which combination of a bank address and a bank group address indicates a bank index among the bank indexes of '1' to '16'. For example, the first refresh management circuit 1170 may generate skip allowance information SAI for each of the memory banks BNK1_D1 to BNK16_D1 and may provide the skip allowance information SAI to the host device 2000.

When a command/address signal CA in which combination of bank address and bank group address indicates a bank index among the bank indexes of '1' to '16' is provided to the first memory device 1100, the same command/address signal CA may also be provided to the second to fourth memory devices 1200 to 1400. In this case, memory banks BNK1_D2 to BNK16_D2, memory banks BNK1_D3 to BNK16_D3, and memory banks BNK1_D4 to BNK16_D4 may be refreshed simultaneously with memory banks BNK1_D1 to BNK16_D1 respectively. Accordingly, the skip allowance information SAI for the memory banks BNK1_D1 to BNK16_D1 generated by the first refresh management circuit 1170 may also correspond to the memory banks BNK1_D2 to BNK16_D2, the memory banks BNK1_D3 to BNK16_D3, and the memory banks BNK1_D4 to BNK16_D4. In other words, the skip allowance information SAI for the memory banks BNK1_D1 to BNK16_D1 may represent (e.g., indicate representatively) the skip allowance information SAI for the memory banks BNK1 to BNK16 of all of the memory devices in a rank. In this way, the first refresh management circuit 1170 may manage refresh operations with respect to corresponding memory banks of the second to fourth memory devices 1200 to 1400 (i.e., memory banks BNK1_D2 to BNK16_D2, memory banks BNK1_D3 to BNK16_D3, and memory banks BNK1_D4 to BNK16_D4) based on the command/address signal CA provided to the first memory device 1100.

Similarly, the second refresh management circuit 1270 may manage memory banks having bank indexes of '17' to '32' (i.e., memory banks BNK17 to BNK32), the third refresh management circuit 1370 may manage memory banks having bank indexes of '33' to '48' (i.e., memory banks BNK33 to BNK48), and the fourth refresh management circuit 1470 may manage memory banks having bank indexes of '49' to '64' (i.e., memory banks BNK49 to BNK64).

That is, the memory banks BNKs managed by each of the first to fourth refresh management circuits 1170 to 1470 may be different from each other. In other words, the memory banks BNKs managed by each of the first to fourth refresh management circuits 1170 to 1470 may be mutually exclusive.

In an embodiment, the first to fourth refresh management circuits 1170 to 1470 may manage refresh operations for same number of memory banks (e.g., sixteen memory banks). In this case, since the first to fourth memory devices 1100 to 1400 may have same design, the production efficiency for the memory module 1000 may be increased. However, the scope of the present disclosure is not limited thereto. For example, each of the first to fourth memory devices 1100 to 1400 may be implemented to manage refresh operations for different number of memory banks.

In an embodiment, the memory module 1000 may further include an error correction code (ECC) die. The ECC die may share command/address signals CA with the first to fourth memory devices 1100 to 1400. In this case, unlike as illustrated in FIG. 10, the ECC die may be implemented to manage refresh operations for some of the range of bank indexes '1' to '64' described above. However, the scope of the present disclosure is not limited thereto.

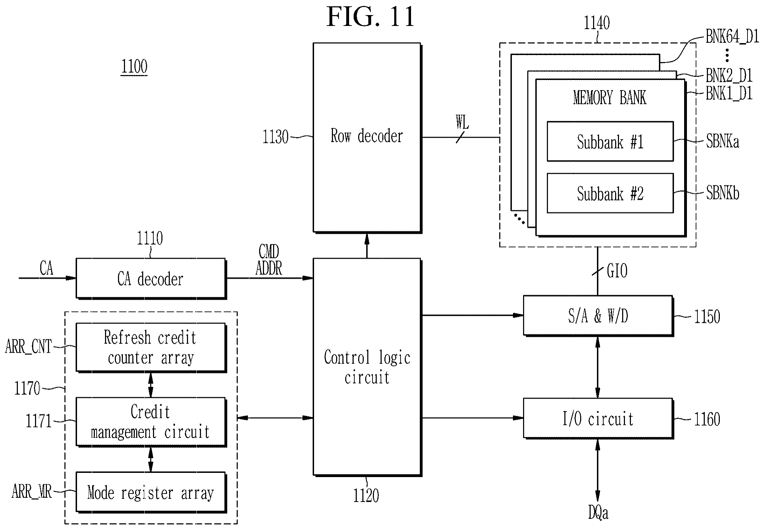

FIG. 11 is a block diagram showing in more detail the configuration of one memory device according to the embodiment of FIG. 10. Below, the configuration of the first memory device 1100 is exemplarily described with reference to FIGS. 1 to 11. However, the scope of the present disclosure is not limited thereto, and the second to fourth memory devices 1200 to 1400 may also be implemented in a similar manner.

The first memory device 1100 may include a command/address decoder 1110, a control logic circuit 1120, a row decoder 1130, a memory bank array 1140, a sense amplifier and write driver 1150, an input/output circuit 1160, and a first refresh management circuit 1170.

The command/address decoder 1110 may receive command/address signal CA from the register clock driver RCD. The command/address decoder 1110 may decode the command/address signal CA into a command CMD and an address ADDR.

The control logic circuit 1120 may receive the command CMD and the address ADDR. The control logic circuit 1120 may control overall operations of the first memory device 1100 based on the command CMD and the address ADDR. For example, the control logic circuit 1120 may control the operation of the row decoder 1130, the sense amplifier and write driver 1150, the input/output circuit 1160, and the first refresh management circuit 1170 based on the command CMD and the address ADDR.

The row decoder 1130 may be connected to the memory bank array 1140 through a plurality of word lines WL. The row decoder 1130 may control the plurality of word lines WL in response to the control of the control logic circuit 1120. For example, the row decoder 1130 may activate some of the plurality of word lines WL in response to control of the control logic circuit 1120.

The memory bank array 1140 may be connected to a row decoder 1130 through a plurality of word lines WLs and to a sense amplifier and write driver 1150 through a plurality of global input/output lines GIOs.

The memory bank array 1140 may include memory banks BNK1_D1 to BNK64_D1. Each of the memory banks BNK1_D1 to BNK64_D1 may be connected to a different group of word lines WL and may be connected to a different group of global input/output lines GIO.

In an embodiment, the number of word lines WL connected to each of the memory banks BNK1_D1 to BNK64_D1 may be same. However, the scope of the present disclosure is not limited thereto.

Each of the memory banks BNK1_D1 to BNK64_D1 may include a plurality of sub-banks SBNK. For example, the memory bank BNK1_D1 may include a first sub-bank SBNKa and a second sub-bank SBNKb. The first sub-bank SBNKa and the second sub-bank SBNKb may be connected to different group of word lines WL. The first sub-bank SBNKa and the second sub-bank SBNKb may be connected to the plurality of global input/output lines GIOs. That is, the first sub-bank SBNKa and the second sub-bank SBNKb may share the plurality of global input/output lines GIOs.

In an embodiment, the number of word lines WL connected to the first sub-bank SBNKa and the second sub-bank SBNKb may be equal to each other. However, the scope of the present disclosure is not limited thereto.

In an embodiment, each of the first sub-bank SBNKa and the second sub-bank SBNKb may include a plurality of memory cells arranged in a matrix form. Each of the plurality of memory cells included in the first sub-bank SBNKa and the second sub-bank SBNKb may be a dynamic random access memory (DRAM) cell. However, the scope of the present disclosure is not limited thereto.

The sense amplifier and write driver 1150 may be connected to the memory bank array 1140 through the plurality of global input/output lines GIO. The sense amplifier and write driver 1150 may receive data from the memory bank array 1140 through the plurality of global input/output lines GIOs or store data in the memory bank array 1140 through the plurality of global input/output lines GIOs.

The input/output circuit 1160 may be connected to a first plurality of data pins DQa. That is, the input/output circuit 1160 may communicate with the host device 2000 through the first plurality of data pins DQa. For example, the input/output circuit 1160 may provide data received from the host device 2000 to the sense amplifier and write driver 1150, or transmit data provided from the sense amplifier and write driver 1150 to the host device 2000.

The first refresh management circuit 1170 may include a refresh credit counter array ARR_CNT, a mode register array ARR_MR, and a credit management circuit 1171.

The refresh credit counter array ARR_CNT may store refresh credit counts CRDT for memory banks BNK managed by the first refresh management circuit 1170.

The credit management circuit 1171 may control overall operations of the first refresh management circuit 1170. For example, The credit management circuit 1171 may adjust the values of refresh credit counts CRDT stored in the refresh credit counter array ARR_CNT and may generate skip allowance information SAI based on the values of the refresh credit counts CRDT.

The mode register array ARR_MR may include a plurality of mode registers (MR). Each of the plurality of mode registers MR may be implemented to store a predetermined type of information. For example, each mode register MR may store information necessary for the operation of the first memory device 1100 or information indicating a status of the first memory device 1100.

In an embodiment, the credit management circuit 1171 may store skip allowance information SAI in the mode register array ARR_MR. That is, the mode register array ARR_MR may be implemented to temporarily store skip allowance information SAI. For example, some of the mode registers MR included in the mode register array ARR_MR may store skip allowance information SAI provided from the credit management circuit 1171. In this case, the host device 2000 may read (e.g., poll) skip allowance information SAI from the mode register array ARR_MR by issuing a mode register read command MRR.

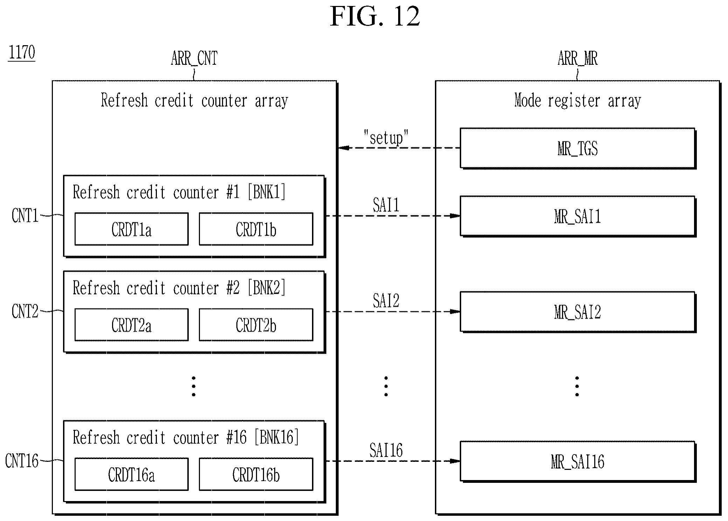

FIG. 12 is a drawing showing the operation of the first refresh management circuit of FIG. 11 in more detail. Referring to FIGS. 1 to 12, the refresh credit counter array ARR_CNT may include first to sixteenth refresh credit counters CNT1 to CNT16.

The mode register array ARR_MR may include a target setup mode register MR_TGS, and first to sixteenth skip allowance information mode registers MR_SAI1 to MR_SAI16.

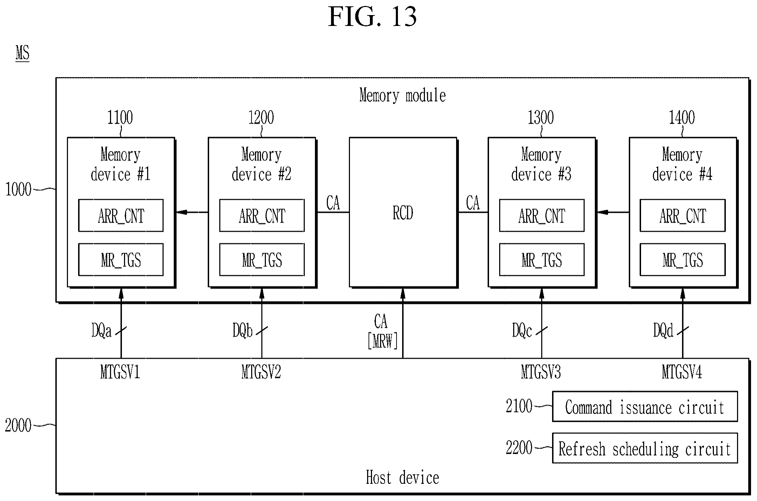

The target setup mode register MR_TGS may indicate which memory banks are managed by the refresh credit counter array ARR_CNT for tracking refresh credit counts CRDT. For example, the value of the target setup mode register MR_TGS included in the first refresh management circuit 1170 may indicate the refresh credit counter array ARR_CNT included in the first refresh management circuit 1170 to manage the refresh credit count CRDT for the memory banks BNK1 to BNK16. Similarly, the value of the target setup mode register MR_TGS included in the second refresh management circuit 1270 may indicate the refresh credit counter array ARR_CNT included in the second refresh management circuit 1270 to manage the refresh credit count CRDT for the memory banks BNK17 to BNK32. In this way, the value of the target setup mode register MR_TGS included in each memory device may indicate memory banks that are managed by each memory device for tracking the refresh credit counts CRDTs. A procedure of setting the value of the target setup mode register MR_TGS in each memory device is described in more detail with reference to FIG. 13 below.

The first to sixteenth refresh credit counters CNT1 to CNT16 may store refresh credit counts CRDT for the memory banks BNK1 to BNK16, respectively. For example, the first refresh credit counter CNT1 may store refresh credit counts CRDT1a, CRDT1b corresponding to the first and second sub-banks SBNKa, SBNKb, respectively. Similarly, each of the second to sixteenth refresh credit counters CNT2 to CNT16 may store refresh credit counts CRDT for two sub-banks of each of the memory banks BNK2 to BNK16, respectively.

The credit management circuit 1171 may manage the refresh credit counts CRDT stored in the first to sixteenth refresh credit counters CNT1 to CNT16 based on the command/address signal CA provided to the command/address decoder 1110 (e.g., by snooping the command/address signal CA; or based on a notification, which is generated when the control logic circuit 1120 operates in response to the command/address signal CA, provided to the credit management circuit 1171). For example, when the command/address signal CA indicates a regular refresh command REF_REG for the memory banks BNK1, the credit management circuit 1171 may increase the refresh credit counts CRDT1a, CRDT1b by the skip cost CST_SKP. For another example, if the command/address signal CA indicates a bank index of '1' and the row address included in the command/address signal CA is a hidden refresh command HR corresponding to a word line WL connected to the first sub-bank SBNKa (i.e., a hidden refresh command HR instructing a hidden refresh operation for the second sub-bank SBNKb), the credit management circuit 1171 may increase the refresh credit count CRDT1b by '1'. As another example, the credit management circuit 1171 may decrease the value of the refresh credit counts CRDT stored in the refresh credit counter array ARR_CNT by the skip cost CST_SKP whenever the regular refresh interval tREFI_REG elapses. In this way, the credit management circuit 1171 may manage the values of refresh credit counts CRDT stored in the refresh credit counter array ARR_CNT.

The credit management circuit 1171 may generate skip allowance information SAI based on the values of refresh credit counts CRDT stored in the refresh credit counter array ARR_CNT. For example, the credit management circuit 1171 may generate the first to sixteenth skip allowance information SAI1 to SAI16 based on the refresh credit counts CRDT stored in the first to sixteenth refresh credit counters CNT1 to CNT16, respectively. In this case, the first to sixteenth skip allowance information SAI1 to SAI16 may correspond to the memory banks BNK1 to BNK16, respectively. That is, each of the first to sixteenth skip allowance information SAI1 to SAI16 may indicate how many times of regular refresh operation for corresponding memory bank may be skipped in the next refresh management period RMP. The method by which each of the first to sixteenth skip allowance information SAI1 to SAI16 is determined has been described above with reference to FIGS. 6 to 9, so a detailed description is omitted.

The credit management circuit 1171 may store one or more skip allowance information SAI in the first to sixteenth skip allowance information mode registers MR_SAI1 to MR_SAI16. For example, the credit management circuit 1171 may store the first to sixteenth skip allowance information SAI1 to SAI16 in the first to sixteenth skip allowance information mode registers MR_SAI1 to MR_SAI16, respectively.

For a more concise explanation, an embodiment is representatively described in FIG. 12 in which skip allowance information SAI for one memory bank BNK is stored in one skip allowance information mode register MR_SAI. However, the scope of the present disclosure is not limited thereto. For example, the mode register array ARR_MR may include a number of skip allowance information mode registers MR_SAI which is smaller than the number of refresh credit counters CNTs included in the refresh credit counter array ARR_CNT. For a more detailed example, the credit management circuit 1171 may be implemented to store the first and second skip allowance information SAI1, SAI2 in the first skip allowance information mode register MR_SAI1, and may be implemented to store the third and fourth skip allowance information SAI3, SAI4 in the second skip allowance information mode register MR_SAI2. In this manner, the credit management circuit 1171 may be implemented to store skip allowance information SAI for two or more memory banks BNKs in one skip allowance information mode register MR_SAI.

In an embodiment, the credit management circuit 1171 may be implemented to store the values stored in the refresh credit counters CNT directly (e.g., itself) into the mode register array ARR_MR. However, the scope of the present disclosure is not limited thereto.

In an embodiment, the credit management circuit 1171 may be implemented to generate skip allowance information SAI whenever a smaller value of the refresh credit counts CRDT stored in one refresh credit counter CNT reaches an integer multiple of the skip cost CST_SKP. However, the scope of the present disclosure is not limited thereto.

FIG. 13 is a diagram showing how the memory banks to be managed by each memory device of FIG. 10 are determined. Referring to FIGS. 1 to 13, each of the first to fourth memory devices 1100 to 1400 may include a refresh credit counter array ARR_CNT and a target setup mode register MR_TGS. The configuration and function of the refresh credit counter array ARR_CNT and the target setup mode register MR_TGS have been described with reference to FIGS. 10 to 12 above, so a detailed description is omitted.

In an embodiment, the mode register addresses of the target setup mode registers MR_TGS included in each of the first to fourth memory devices 1100 to 1400 may be the same.

The host device 2000 may issue a mode register write command MRW in the form of a command/address signal CA. For example, the command issuance circuit 2100 may issue a mode register write command MRW together with the mode register address of the target setup mode register MR_TGS.

Each memory device may receive different management target setup values MTGSV from the host device 2000 through a plurality of data pins DQ in response to a mode register write command MRW. For example, the first to fourth memory devices 1100 to 1400 may receive the first to fourth management target setup values MTGSV1 to MTGSV4 from the host device 2000 in response to the mode register write command MRW.

Each memory device may write the received management target setup value MTGSV to the target setup mode register MR_TGS in response to a mode register write command MRW. For example, the first memory device 1100 may write the first management target setup value MTGSV1 into the target setup mode register MR_TGS included in the first memory device 1100, and the second memory device 1200 may write the second management target setup value MTGSV2 into the target setup mode register MR_TGS included in the second memory device 1200.

That is, the host device 2000 may collectively set the target setup mode register MR_TGS included in each of the first to fourth memory devices 1100 to 1400 by issuing one mode register write command MRW.

In an embodiment, the first to fourth management target setup values MTGSV1 to MTGSV4 may be different from each other. In this case, since each memory device operates based on a different management target setup value MTGSV, the memory banks managed by each memory device may be different from one another.

The command issuance circuit 2100 may also provide information of the first to fourth management target setup values MTGSV1 to MTGSV4 to the refresh scheduling circuit 2200. Based on the information of the first to fourth management target setup values MTGSV1 to MTGSV4, the refresh scheduling circuit 2200 may determine memory banks of the memory devices on which the refresh operation is managed.

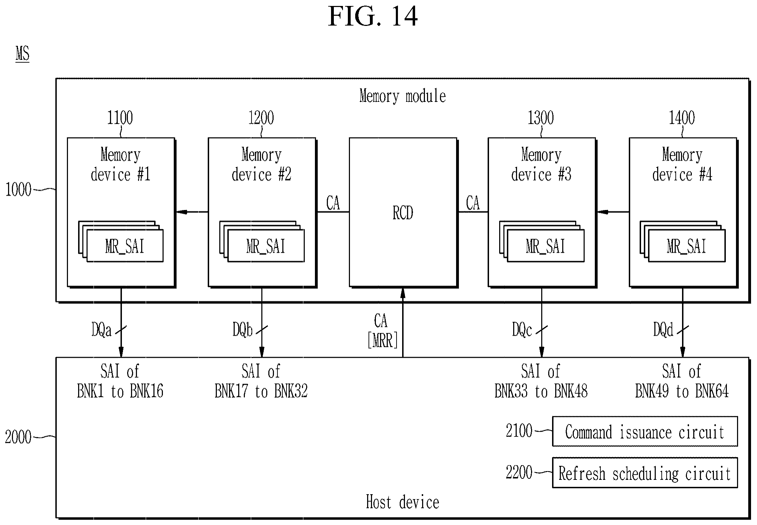

FIG. 14 is a diagram showing how a host device reads skip allowance information from the memory devices of FIG. 10. Referring to FIGS. 1 to 14, each of the first to fourth memory devices 1100 to 1400 may include a plurality of skip allowance information mode registers MR_SAI. The configuration and function of the skip allowance information mode register MR_SAI have been described with reference to FIGS. 10 to 12 above, so a detailed description is omitted.

In an embodiment, the ranges of mode register addresses corresponding to the skip allowance information mode registers MR_SAI included in each of the first to fourth memory devices 1100 to 1400 may be the same. For example, the mode register numbers (e.g., mode register addresses) of the skip allowance information mode registers MR_SAI included in the first memory device 1100 may be identical to the mode register numbers of the skip allowance information mode registers MR_SAI included in the second memory device 1200.

The host device 2000 may issue a mode register read command MRR in a form of command/address signal CA. For example, the command issuance circuit 2100 may issue a mode register read command MRR together with a mode register address of a specific skip allowance information mode register MR_SAI.

Each memory device may output skip allowance information SAI stored in skip allowance information mode registers MR_SAI corresponding to the mode register read command MRR to the host device 2000 through the plurality of data pins DQ. For example, the first memory device 1100 may output skip allowance information SAI for the memory banks BNK1 to BNK16 to the host device 2000 through the first plurality of data pins DQa in response to the mode register read command MRR, and the second memory device 1200 may output skip allowance information SAI for the memory banks BNK17 to BNK32 to the host device 2000 through the second plurality of data pins DQb in response to the mode register read command MRR.

In this manner, the host device 2000 may receive the skip allowance information SAI from different memory devices by issuing one mode register read command MRR. In this case, the refresh scheduling circuit 2200 may identify that which memory device has provided the skip allowance information SAI based on data pins DQ output the skip allowance information SAI, and thus the refresh scheduling circuit 2200 may identify a group of memory banks in which the memory bank corresponding to the skip allowance information SAI is included. For example, the refresh scheduling circuit 2200 may identify that the skip allowance information SAI received through the first plurality of data pins DQa corresponds to one of the memory banks BNK1 to BNK16; and may identify that the skip allowance information SAI received through the second plurality of data pins DQb corresponds to one of the memory banks BNK17 to BNK32. In an embodiment, the refresh scheduling circuit 2200 may determine memory bank BNK to which the skip allowance information SAI corresponds based on the mode register address issued along with the mode register read command MRR.

In this manner, the host device 2000 may sequentially issue a plurality of mode register read commands MRR for different skip allowance information mode registers MR_SAI to read skip allowance information SAI corresponding to bank indexes '1' to '64' from the memory module 1000. For example, the host device 2000 may issue a mode register read command MRR corresponding to the first skip allowance information mode registers MR_SAI1 described above with reference to FIG. 12 to read out skip allowance information SAI corresponding to bank indexes '1', '17', '33', and 49' from the memory module 1000, and may issue a mode register read command MRR corresponding to the second skip allowance information mode register MR_SAI2 described above with reference to FIG. 12 to read out skip allowance information SAI corresponding to bank indexes '2', '18', '34', and 50' from the memory module 1000. However, the scope of the present disclosure is not limited thereto. For example, the host device 2000 may not issue a mode register read command MRR for certain skip allowance information mode registers MR_SAI.

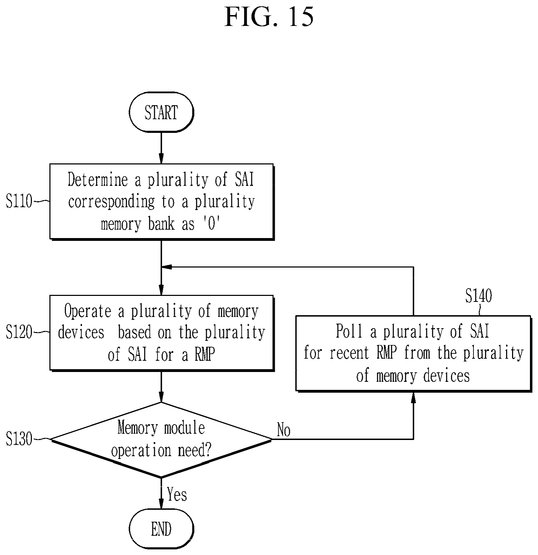

FIG. 15 is a flowchart showing how a host device controls the operation of a memory module according to an embodiment of the present disclosure.

Referring to FIGS. 1 to 15, at operation S110, the host device 2000 may determine skip allowance information SAI corresponding to a plurality of memory banks BNK as '0'. For example, when the memory module 1000 is booted up, the host device 2000 may poll the skip allowance information SAI of '0' corresponding to each of the plurality of memory banks BNKs from the memory module 1000. However, the scope of the present disclosure is not limited thereto, and when the memory module 1000 is booted up, the host device 2000 may regard the skip allowance information SAI corresponding to each of the plurality of memory banks as '0' even if it does not poll skip allowance information SAI from the memory module 1000.

At operation S120, the host device 2000 may drive the plurality of memory devices based on the plurality of skip allowance information SAI during one refresh management period RMP. For example, the host device 2000 may determine the number of times to issue regular refresh commands REF_REG and hidden refresh commands HR for each memory bank BNK during one refresh management period RMP based on a plurality of skip allowance information SAI.

At operation S130, the host device 2000 may determine whether further operations on the memory module 1000 is required. If it is determined that further operations on the memory module 1000 is required, the following operation S140 may be performed. If it is determined that no further operation is required for the memory module 1000, the host device 2000 may terminate issuing operation command to the memory module 1000.

At operation S140, the host device 2000 may poll the skip allowance information SAI for recent refresh management period RMP from the plurality of memory devices. For example, the host device 2000 may sequentially issue one or more mode register read commands MRR to read skip allowance information SAI stored in a skip allowance information mode register MR_SAI included in each memory device.

After operation S140 is performed, operation S120 described above may be performed recurrently. In this case, the host device 2000 may drive the plurality of memory devices during the next refresh management period RMP based on the skip allowance information SAI received at operation S140. In this way, the host device 2000 may determine the number of times to issue regular refresh commands REF_REG and hidden refresh commands HR in each refresh management period RMP based on skip allowance information SAI for the previous refresh management period RMP. Accordingly, an optimum number of refresh operations may be performed for each memory bank BNK, thereby improving the operational efficiency of the memory system MS.

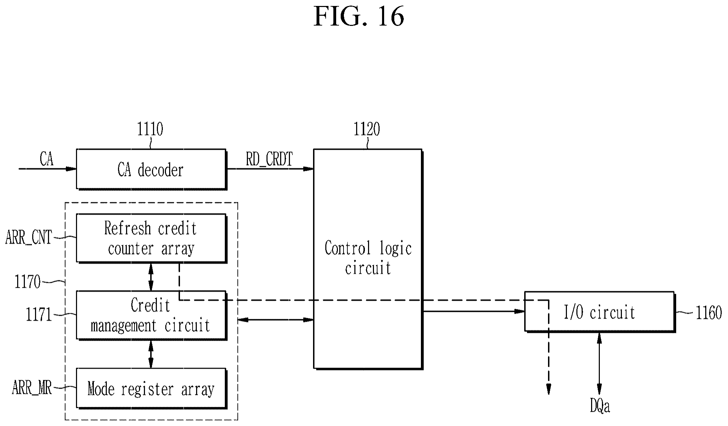

FIG. 16 is a diagram showing how a host device reads a refresh credit count according to an embodiment. For a more concise explanation, only relevant components of the first memory device 1100 are shown in FIG. 16.

Referring to FIGS. 1 to 12 and FIG. 16, a host device 2000 may issue a command/address signal CA indicating a refresh credit count read command RD_CRDT. The command/address decoder 1110 may decode the command/address signal CA provided from the host device 2000 into a refresh credit count read command RD_CRDT. In response to the refresh credit count read command RD_CRDT, the control logic circuit 1120 may provide one or more refresh credit counts CRDTs stored in the refresh credit counter array ARR_CNT to the host device 2000 through the input/output circuit 1160 and the first plurality of data pins DQa. In this case, the control logic circuit 1120 may provide the host device 2000 with the refresh credit counts CRDT stored in one refresh credit counter CNT as well as the refresh credit counts CRDT stored in a plurality of refresh credit counters CNT.

That is, instead of reading the skip allowance information SAI based on the mode register read command MRR, the host device 2000 may issue a refresh credit count read command RD_CRDT to read the refresh credit counts CRDT directly from the refresh credit counter array ARR_CNT. However, the scope of the present disclosure is not limited thereto.

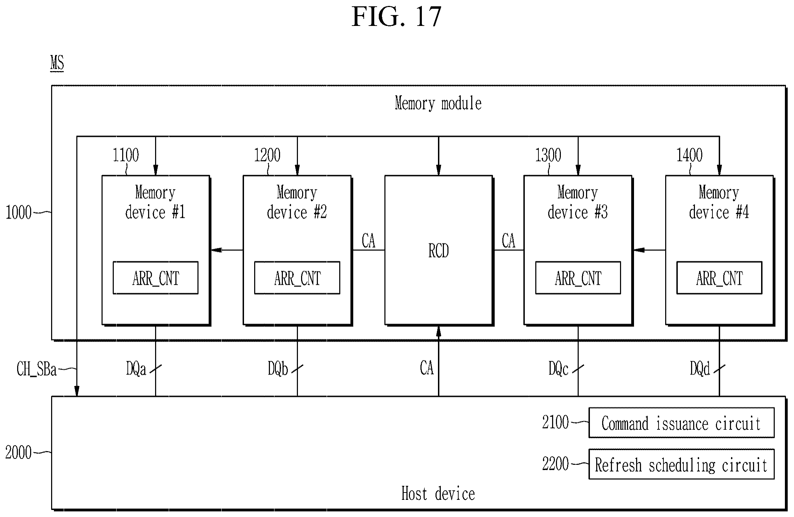

FIG. 17 is a diagram showing how a host device accesses a refresh credit counter array included in each memory device according to an embodiment. Referring to FIGS. 1 to 12 and 17, each of the first to fourth memory devices 1100 to 1400 may include a refresh credit counter array ARR_CNT. The host device 2000 may be connected to each of the first to fourth memory devices 1100 to 1400 through a side band channel CH_SBa.

The host device 2000 may access the refresh credit counter array ARR_CNT of each of the first to fourth memory devices 1100 to 1400 through the side band channel CH_SBa. For example, even if the host device 2000 does not issue a command/address signal CA, the host device may read out refresh credit counts CRDT stored in the refresh credit counter array ARR_CNT included in each of the first to fourth memory devices 1100 to 1400 through the side band channel CH_SBa. However, the scope of the present disclosure is not limited thereto, and the host device 2000 may also read out skip allowance information SAI through the side band channel CH_SBa.

In an embodiment, the side band channel CH_SBa may be implemented based on at least one of serial communication protocols, such as I2C (inter integrated circuit), I3C (Improved Inter Integrated Circuit), SMBus (system management bus), and UART (universal asynchronous receiver/transmitter). However, the scope of the present disclosure is not limited thereto.

In an embodiment, the host device 2000 may collect status information of each of the first to fourth memory devices 1100 to 1400 through the side band channel CH_SBa. For example, each of the first to fourth memory devices 1100 to 1400 may include a temperature sensor, and the temperature sensor included in each memory device may transmit a temperature value to the host device 2000 through the side band channel CH_SBa. That is, the side band channel CH_SBa may be implemented to transmit not only refresh credit counts CRDTs but also any type of status information for each of the first to fourth memory devices 1100 to 1400.

FIG. 18 is a block diagram showing how a register clock driver manages the plurality of refresh credit counts according to an embodiment of the present disclosure. Referring to FIGS. 1 to 9 and 18, a memory module 1000 may include first to fourth memory devices 1100 to 1400 and a register clock driver RCD. Since the configuration of the first to fourth memory devices 1100 to 1400 has been described above with reference to FIG. 1, a detailed description thereof is omitted.

The register clock driver RCD may include a refresh management circuit RMC. The refresh management circuit RMC may manage refresh operations for memory banks BNKs included in the memory module 1000 based on a command/address signal CA provided to the register clock driver RCD. For example, the refresh management circuit RMC may determine which memory bank BNK has been subjected to a regular refresh operation and which memory bank BNK has been subjected to a hidden refresh operation based on the command/address signal CA provided to the register clock driver RCD. That is, according to the embodiment of FIG. 18, unlike the embodiment described with reference to FIGS. 12 to 17, the refresh credit count CRDT may not be managed in each memory device, and all refresh credit counts CRDT may be managed in the register clock driver RCD. In this case, the design complexity of each memory device may be reduced, so the production efficiency of each memory device may be increased.

The host device 2000 may be connected to the register clock driver RCD through a side band channel CH_SBb. The host device 2000 may access the refresh management circuit RMC through the side band channel CH_SBb. For example, the host device 2000 may read data stored in the refresh management circuit RMC through the side band channel CH_SBb rather than the data pins DQ.

In an embodiment, the side band channel CH_SBb may be implemented based on at least one of serial communication protocols, such as I2C (inter integrated circuit), I3C (Improved Inter Integrated Circuit), SMBus (system management bus), and UART (universal asynchronous receiver/transmitter). However, the scope of the present disclosure is not limited thereto.

FIG. 19 is a drawing showing the configuration of the refresh management circuit of FIG. 18 in more detail. Referring to FIGS. 1 to 9 and FIGS. 18 to 19, the refresh management circuit RMC may include first to sixty-fourth refresh credit counters CNT1 to CNT64.

The first to sixty-fourth refresh credit counters CNT1 to CNT64 may store refresh credit counts CRDTs corresponding to different bank indexes. For example, the first to sixty-fourth refresh credit counters CNT1 to CNT64 may store refresh credit counts CRDTs for memory banks having bank indexes of '1' to '64', respectively (i.e., the memory banks BNK1 to BNK64 described above with reference to FIG. 10).

The refresh management circuit RMC may manage refresh credit counts CRDT stored in the first to sixty-fourth refresh credit counters CNT1 to CNT64 based on a command/address signal CA provided from a host device 2000. The specific manner in which the refresh management circuit RMC manages the refresh credit counts CRDT stored in the first to sixty-fourth refresh credit counters CNT1 to CNT64 based on the command/address signal CA is similar to the manner in which the credit management circuit 1171 described above with reference to FIG. 12 manages the refresh credit counts CRDT, and therefore a detailed description thereof is omitted.

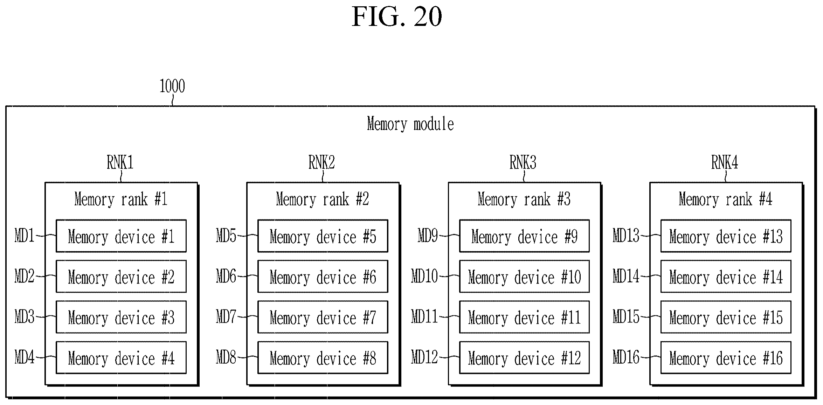

FIG. 20 is a diagram showing the configuration of a memory module according to an embodiment. Referring to FIGS. 1 to 20, a memory module 1000 may include a plurality of memory ranks RNKs. For example, the memory module 1000 may include first to fourth memory ranks RNK1 to RNK4. For the sake of brevity, an embodiment is illustrated below in which a memory module 1000 includes four memory ranks RNKs, but the scope of the present disclosure is not limited thereto. For example, the memory module 1000 may include any number of memory ranks, such as two, four or eight depending on the implementation requirements and performance specifications.

Each of the first to fourth memory ranks RNK1 to RNK4 may include the plurality of memory devices MDs. For example, a first memory rank RNK1 may include first to fourth memory devices MD1 to MD4, a second memory rank RNK2 may include fifth to eighth memory devices MD5 to MD8, a third memory rank RNK3 may include ninth to twelfth memory devices MD9 to MD12, and a fourth memory rank RNK4 may include thirteenth to sixteenth memory devices MD13 to MD16.

Each memory rank RNK may operate in response to a chip select signal and a command/address signal CA provided from the host device 2000. For example, the first to fourth memory ranks RNK1 to RNK4 may share the command/address signal CA. Each of the first to fourth memory ranks RNK1 to RNK4 may receive corresponding one of first to fourth chip select signals. The first memory rank RNK1 may operate in response to the command/address signal CA only when the first chip select signal associated with the first memory rank RNK1 is activated, and the second memory rank RNK2 may operate in response to the command/address signal CA only when the second chip select signal associated with the second memory rank RNK2 is activated. However, the scope of the present disclosure is not limited to the specific manner in which each memory rank RNK operates.

The memory devices MD included in one memory rank RNK may operate collectively in response to a command/address signal CA. For example, when the first chip select signal associated with the first memory rank RNK1 is activated, the first to fourth memory devices MD1 to MD4 may be simultaneously controlled based on the command/address signal CA.

That is, the memory devices MD included in one memory rank RNK may correspond to the first to fourth memory devices 1100 to 1400 described above with reference to FIGS. 1 to 19. For example, the first to fourth memory devices MD1 to MD4 may be implemented to manage refresh operations corresponding to different bank indexes similarly to the first to fourth memory devices 1100 to 1400 described with reference to FIGS. 10 to 17 above.

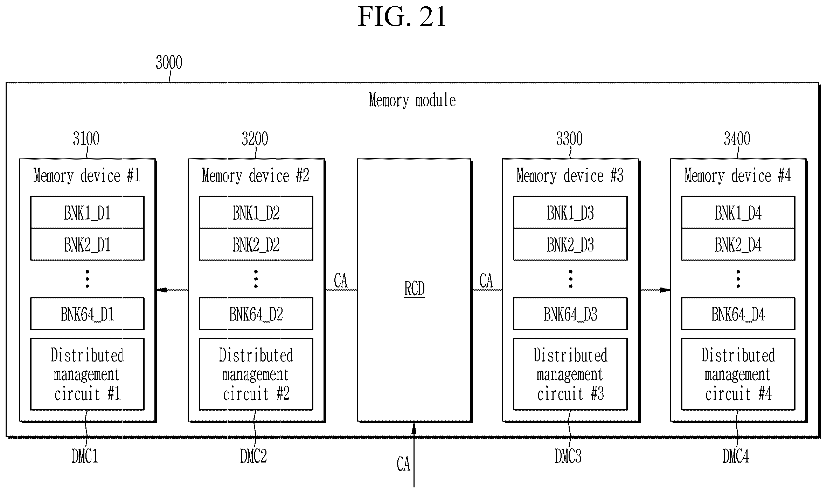

FIG. 21 is a block diagram showing the configuration of a memory module according to an embodiment. Referring to FIG. 21, the memory module 3000 may include first to fourth memory devices 3100 to 3400 and a register clock driver RCD.

Each of the first to fourth memory devices 3100 to 3400 may include the plurality of memory banks BNKs. For example, a first memory device 3100 may include memory banks BNK1_D1 to BNK64_D1, a second memory device 3200 may include memory banks BNK1_D2 to BNK64_D2, a third memory device 3300 may include memory banks BNK1_D3 to BNK64_D3, and a fourth memory device 3400 may include memory banks BNK1_D4 to BNK64_D4.

The register clock driver RCD may receive a command/address signal CA and broadcast the command/address signal CA to the first to fourth memory devices 3100 to 3400.

The first to fourth memory devices 3100 to 3400 may each include first to fourth distributed management circuits DMC1 to DMC4. The first to fourth distributed management circuits DMC1 to DMC4 may manage status information on memory banks BNKs included in a memory module 3000 based on a command/address signal CA in distributed manner.

In an embodiment, the status information managed by the first to fourth distributed management circuits DMC1 to DMC4 may be information indicating the number of refresh commands (e.g., hidden refresh, regular refresh, etc.) issued to each memory bank, similar to refresh management method described with reference to FIG. 10. However, the scope of the present disclosure is not limited thereto. For example, the command/address signal CA may represent any type of refresh command, as well as a hidden refresh command HR and a regular refresh command REF_REG. In this case, the status information managed by the first to fourth distributed management circuits DMC1 to DMC4 may also indicate a number of refresh commands have been received. Furthermore, the status information managed by the first to fourth distributed management circuits DMC1 to DMC4 may be any type of status information managed within the memory module 3000 in response to an operation command through a command/address signal CA. For example, the status information managed by the first to fourth distributed management circuits DMC1 to DMC4 may be any type of status information managed within the memory module 3000 in response to the operation command through the command/address signal CA, such as a number of the refresh commands received, a number of the activation commands received, a number of read commands received, a number of write commands received, a number of precharge commands received, etc. That is, the scope of the present disclosure is not limited to the specific types of state information managed by the first to fourth distributed management circuits DMC1 to DMC4.

In an embodiment, when the status information managed by the first to fourth distributed management circuits DMC1 to DMC4 is information indicating the number of refresh commands (e.g., hidden refresh, regular refresh, etc.) for each memory bank that have been received, the first to fourth distributed management circuits DMC1 to DMC4 may also be referred to as refresh management circuits. That is, if the status information managed by the first to fourth distributed management circuits DMC1 to DMC4 indicates the number refresh commands of any type that have been received, regardless of the specific implementation method of each memory bank (for example, even if each memory bank does not include a plurality of sub-banks), the first to fourth distributed management circuits DMC1 to DMC4 may also be referred to as 'refresh management circuits.' However, the scope of the present disclosure is not limited to these terms.

In an embodiment, each of the first to fourth distributed management circuits DMC1 to DMC4 may manage status information for memory banks corresponding to different bank index ranges, similar to refresh management that was described above with reference to FIG. 10. For example, a first distributed management circuit DMC1 may manage status information for memory banks BNK1 to BNK16, a second distributed management circuit DMC2 may manage status information for memory banks BNK17 to BNK32, a third distributed management circuit DMC3 may manage status information for memory banks BNK33 to BNK48, and a fourth distributed management circuit DMC4 may manage status information for memory banks BNK49 to BNK64. However, the scope of the present disclosure is not limited to the specific manner in which the management scope of state information is distributed to each of the first to fourth distributed management circuits DMC1 to DMC4.

In an embodiment, each of the first to fourth distributed management circuits DMC1 to DMC4 may manage state information corresponding to different row address ranges. For example, each of the memory banks BNKs included in the memory module 3000 may be divided into first to fourth sub-areas corresponding to the first to fourth row address ranges, respectively. That is, each memory bank BNK may include a first sub-area corresponding to a first row address range, a second sub-area corresponding to a second row address range, a third sub-area corresponding to a third row address range, and a fourth sub-area corresponding to a fourth row address range. In this case, the first distributed management circuit DMC1 may manage status information for the first sub-area of each memory bank BNK, the second distributed management circuit DMC2 may manage status information for the second sub-area of each memory bank BNK, the third distributed management circuit DMC3 may manage status information for the third sub-area of each memory bank BNK, and the fourth distributed management circuit DMC4 may manage status information for the fourth sub-area of each memory bank BNK. However, the scope of the present disclosure is not limited to the specific manner in which the management of state information is distributed to each of the first to fourth distributed management circuits DMC1 to DMC4.

In an embodiment, state information managed by each of the first to fourth distributed management circuits DMC1 to DMC4 may be provided to a host device accessing the memory module 3000 in the manner described above with reference to FIGS. 10 to 17. However, the scope of the present disclosure is not limited thereto.

In an embodiment, the range and type of state information managed by each of the first to fourth distributed management circuits DMC1 to DMC4 may be set in the manner described above with reference to FIG. 13. However, the scope of the present disclosure is not limited thereto.

In an embodiment, state information managed by each of the first to fourth distributed management circuits DMC1 to DMC4 may be provided to a host device accessing the memory module 3000 in the manner described above with reference to FIGS. 10 to 17. However, the scope of the present disclosure is not limited thereto.

In this way, the range of state information managed by each of the first to fourth distributed management circuits DMC1 to DMC4 may not overlap with each other. In other words, the range of state information managed by each of the first to fourth distributed management circuits DMC1 to DMC4 may be mutually exclusive. In this case, even if each memory device does not manage status information for all memory banks BNKs, status information for all memory banks BNKs may be managed at the memory module 3000 level. Therefore, according to the embodiment of FIG. 21, the efficiency of status information management of the memory module 3000 may be maximized, and the production cost of the memory module 3000 may be minimized.

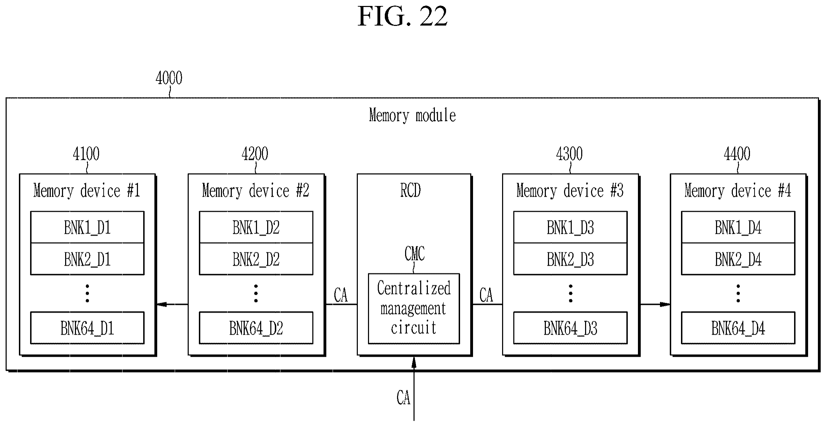

FIG. 22 is a block diagram showing the configuration of a memory module according to an embodiment. Referring to FIG. 22, the memory module 4000 may include first to fourth memory devices 4100 to 4400 and a register clock driver RCD.

Each of the first to fourth memory devices 4100 to 4400 may include the plurality of memory banks BNKs. For example, a first memory device 4100 may include memory banks BNK1_D1 to BNK64_D1, a second memory device 4200 may include memory banks BNK1_D2 to BNK64_D2, a third memory device 4300 may include memory banks BNK1_D3 to BNK64_D3, and a fourth memory device 4400 may include memory banks BNK1_D4 to BNK64_D4.

The register clock driver RCD may receive a command/address signal CA and broadcast the command/address signal CA to the first to fourth memory devices 4100 to 4400.

The register clock driver RCD may include a central management circuit CMC. The central management circuit CMC may manage status information for memory banks BNKs included in a memory module 4000 based on a command/address signal CA provided to a register clock driver RCD.

Status information managed by the central management circuit CMC may be information indicating a number of refresh commands (e.g., hidden refresh, regular refresh, etc.) that have been received for each memory bank. However, the scope of the present disclosure is not limited to the specific types of state information managed by the central management circuit CMC. For example, similarly to state information management that was described above with reference to FIG. 21, the status information managed by the central management circuit CMC may be any type of status information managed within the memory module 4000 in response to the command/address signal CA.

In an embodiment, status information managed by the central management circuit CMC may be provided to a host device accessing the memory module 4000 in the manner described above with reference to FIG. 18. However, the scope of the present disclosure is not limited thereto.

In this way, the central management circuit CMC may manage state information on behalf of each memory device. In this case, the design complexity of each memory device may be reduced, so the production efficiency of each memory device may be increased.

A memory module according to an embodiment of present disclosure may comprise: a first memory device including a first plurality of memory banks, a second plurality of memory banks, and a first distributed management circuit, and a second memory device including a third plurality of memory banks, a fourth plurality of memory banks, and a second distributed management circuit. The first memory device (1100) and the second memory device (1200) are configured to share a command/address signal (CA), the first distributed management circuit is configured to manage a first status information for the first and third plurality (BNK1_D2-BNK16_D2) of memory banks based on the command/address signal (CA), and the second distributed management circuit is configured to manage a second status information for the second and fourth plurality (BNK17_D2-BNK32_D2) of memory banks based on the command/address signal (CA).

## Claims

1. A memory module (1000), comprising:
a first memory device (1100) including a first plurality (BNK1_D1-BNK16_D1) of memory banks, a second plurality (BNK17_D1-BNK32_D1) of memory banks, and a first refresh management circuit (1170); and
a second memory device (1200) including a third plurality (BNK1_D2-BNK16_D2) of memory banks, a fourth plurality (BNK17_D2-BNK32_D2) of memory banks, and a second refresh management circuit (1270),
wherein the first refresh management circuit (1170) is configured to manage a number of times refresh is performed for the first and third plurality (BNK1_D1-BNK16_D1, BNK1_D2-BNK16_D2) of memory banks, and the second refresh management circuit (1270) is configured to manage a number of times refresh is performed for the second and fourth plurality (BNK17_D1-BNK32_D1, BNK17_D2-BNK32_D2) of memory banks.

2. The memory module (1000) of claim 1, wherein:
the first memory device (1100) and the second memory device (1200) are included in a first memory rank (RNK1).

3. The memory module (1000) of claim 1 or 2, wherein:
the first memory device (1100) and the second memory device (1200) share a command/address signal (CA).

4. The memory module (1000) of any one of claims 1 to 3, wherein, the first plurality (BNK1_D1-BNK16_D1) of memory banks and the third plurality (BNK1_D2-BNK16_D2) of memory banks are configured to be accessed using first combinations of bank addresses and bank group addresses included in a command/address signal (CA), the second plurality (BNK17_D1-BNK32_D1) of memory banks and the fourth plurality (BNK17_D2-BNK32_D2) of memory banks are configured to be accessed using second combinations of the bank addresses and bank group addresses included in the command/address signal (CA), and the first combinations and the second combinations are mutually exclusive.

5. The memory module (1000) of any one of claims 1 to 4, wherein each of the first, second, third and fourth plurality (BNK1_D1-BNK32_D1, BNK1_D2-BNK32_D2) of memory banks includes the same number of memory banks.

6. The memory module (1000) of any one of claims 1 to 5, wherein:
each of the first plurality (BNK1_D1-BNK16_D1) of memory banks includes two sub-banks (SBNK),
the first refresh management circuit (1170) includes a first plurality (CNT1-CNT16) of refresh credit counters respectively corresponding to the first plurality (BNK1_D1-BNK16_D1) of memory banks, and
each of the first plurality (CNT1-CNT16) of refresh credit counters is configured to store two refresh credit counts (CRDT) respectively corresponding to the two sub-banks (SBNK) included in corresponding memory bank.

7. The memory module (1000) of claim 6, wherein:
the first plurality (BNK1_D1-BNK16_D1) of memory banks includes a first memory bank (BNK1_D1),
the first memory bank (BNK1_D1) includes a first sub-bank (SBNKa) and a second sub-bank (SBNKb),
the first plurality (CNT1-CNT16) of refresh credit counters includes a first refresh credit counter (CNT1),
the first refresh credit counter (CNT1) includes a first refresh credit count (CRDTa) for the first sub-bank (SBNKa) and a second refresh credit count (CRDTb) for the second sub-bank (SBNKb), and
the first refresh management circuit (1170) further includes a credit management circuit (1171) configured to decrease the first and second refresh credit counts (CRDTa, CRDTb) at each regular refresh period (tREFI_REG) of a plurality of regular refresh periods (tREFI_REG), to increase the first refresh credit count (CRDTa) whenever the first sub-bank (SBNKa) is refreshed, and to increase the second refresh credit count (CRDTb) whenever the second sub-bank (SBNKb) is refreshed.

8. The memory module (1000) of claim 7, wherein the credit management circuit (1171) is configured to:
increase each of the first and second refresh credit counts (CRDTa, CRDTb) by a first value, in response to a regular refresh command (REF_REG) for the first memory bank (BNK1_D1) being provided to the first memory device (1100),
increase the first refresh credit count (CRDTa) by a second value less than the first value, in response to a hidden refresh command for the first sub- bank being provided to the first memory device (1100);
increase the second refresh credit count (CRDTb) by the second value, in response to a hidden refresh command for the second sub-bank (SBNKb) being provided to the first memory device (1100); and
decrease the first refresh credit count (CRDTa) and the second refresh credit count (CRDTb) by the first value at each regular refresh period (tREFI_REG).

9. The memory module (1000) of claim 7 or 8, wherein:
the first refresh management circuit (1170) further comprises one or more skip allowance information mode registers (MR_SAI) storing one or more pieces of skip allowance information (SAI) generated based on refresh credit counts (CRDT) stored in the first plurality (CNT1-CNT16) of refresh credit counters, and
the first memory device (1100) is configured to, in response to a mode register read command (MRR) provided from an external device (2000), output at least one of the one or more pieces of skip allowance information (SAI) to the external device (2000).

10. The memory module (1000) of claim 9, wherein:
the one or more pieces of skip allowance information (SAI) include first skip allowance information (SAla) corresponding to the first memory bank (BNK1_D1), and
the credit management circuit (1171) is configured to generate the first skip allowance information (SAla) based on a smaller one of the first and second refresh credit counts (CRDTa, CRDTb).

11. The memory module (1000) of claim 10, wherein the credit management circuit (1171) is configured to:
decrease each of the first and second refresh credit counts (CRDTa, CRDTb) by a first value at each regular refresh period (tREFI_REG); and
determine an integer quotient obtained by dividing a smaller one among the first and second refresh credit counts (CRDTa, CRDTb) by the first value, as the first skip allowance information (SAla).

12. The memory module (1000) of any one of claims 6 to 11, wherein:
the first memory device (1100) is configured to output, in response to a refresh credit count read command (RD_CRDT) provided from an external device (2000), at least one of refresh credit counts (CRDT) stored in the first plurality (CNT1-CNT16) of refresh credit counters to the external device (2000).

13. The memory module (1000) of any one of claims 6 to 12, wherein:
the first memory device (1100) is further configured to output refresh credit counts (CRDT) stored in the first plurality (CNT1-CNT16) of refresh credit counters to an external device (2000) through a side band channel.

14. The memory module (1000) of any one of claims 1 to 13, wherein:
the first refresh management circuit (1170) includes a first target setup mode register (MR_TGS) storing a first management target setup value (MTGSV1),
the second refresh management circuit (1270) includes a second target setup mode register (MR_TGS) storing a second management target setup value (MTGSV2),
the first refresh management circuit (1170) is configured to manage the number of times refresh is performed for the first and third plurality (BNK1_D2-BNK16_D2) of memory banks, based on the first management target setup value (MTGSV1), and
the second refresh management circuit (1270) is configured to manage the number of times refresh is performed for the second and fourth plurality of memory bank based on the second management target setup value (MTGSV2).

15. A memory system (MS) comprising:
the memory module (1000) of any one of claims 1 to 14, wherein the first plurality (BNK1_D1-BNK16_D1) of memory banks is identified with a first plurality of bank indexes and the second plurality (BNK17_D1-BNK32_D1) of memory banks is identified with a second plurality of bank indexes, and wherein the third plurality (BNK1_D2-BNK16_D2) of memory banks is identified with the first plurality of bank indexes and the fourth plurality (BNK17_D2-BNK32_D2) of memory banks is identified with the second plurality of bank indexes; and
a host device (2000) configured to:
poll, from the first memory device (1100), first skip allowance information (SAla) generated based on a number of times refresh is performed for the first plurality of bank indexes during a first refresh management period (RMP1); and
determine, based on the first skip allowance information (SAla), a number of times to issue a regular refresh command (REF_REG) for the first and third plurality (BNK1_D2-BNK16_D2) of memory banks in a second refresh management period (RMP2) after the first refresh management period (RMP1).
